# EUROPEAN PATENT APPLICATION

(11) **EP 4 757 524 A1**
(43) Date of publication of application: **10.06.2026**
(21) Application number: 25213763.3
(22) Date of filing: 05.11.2025
(51) Int. Cl.: H10B 63/00, H10N 70/20, H10N 70/00

(54) **SEMICONDUCTOR MEMORY DEVICES**

(30) Priority: 06.12.2024 KR 20240180430
(71) Applicant: Samsung Electronics Co., Ltd., Suwon-si, Gyeonggi-do 16677 (KR)
(72) Inventor: BAE, Taejin, 16677 Suwon-si (KR); ILMOK, Park, 16677 Suwon-si (KR)
(74) Representative: Marks & Clerk LLP

(57) **Abstract**

A semiconductor memory device (1) includes a lower peripheral circuit structure (DPST), an upper peripheral circuit structure (UPST) and a memory cell structure (CST), which overlap each other in a vertical direction, and a plurality of vertical through-electrodes (TSV) configured to electrically connect the lower peripheral circuit structure to the upper peripheral circuit structure. The memory cell structure includes a plurality of word lines (WL), a plurality of bit lines (BL), and a plurality of selectors (SLT) arranged between the plurality of word lines and the plurality of bit lines to constitute a plurality of memory cells (MC). The lower peripheral circuit structure includes a lower semiconductor substrate (PSUBD) and a plurality of lower transistors arranged on the lower semiconductor substrate, and the upper peripheral circuit structure includes an upper semiconductor substrate (PSUBU) and a plurality of upper transistors arranged on the upper semiconductor substrate.

## Description

### BACKGROUND

The demands for miniaturization, multifunctionality, and high performance in electronic products require high-capacity semiconductor memory devices. Accordingly, increased degrees of integration are required to provide high-capacity semiconductor memory devices. Semiconductor memory devices according to the related art include memory cells including information storage elements and selectors, and thus, the degrees of integration of semiconductor memory devices are increasing but still limited.

### SUMMARY

This disclosure provides a semiconductor memory device that operates bidirectionally to increase a degree of integration and improve operating performance.

According to some implementations, there is provided a semiconductor memory device including a lower peripheral circuit structure, an upper peripheral circuit structure, a memory cell structure, which overlap each other in a vertical direction, and a plurality of vertical through-electrodes configured to electrically connect the lower peripheral circuit structure to the upper peripheral circuit structure, wherein the memory cell structure includes a plurality of word lines extending in a first horizontal direction, a plurality of bit lines extending in a second horizontal direction that is different from the first horizontal direction, and a plurality of selectors arranged between the plurality of word lines and the plurality of bit lines to constitute a plurality of memory cells, the lower peripheral circuit structure includes a lower semiconductor substrate and a plurality of lower transistors arranged on the lower semiconductor substrate, the upper peripheral circuit structure includes an upper semiconductor substrate and a plurality of upper transistors arranged on the upper semiconductor substrate, each of the plurality of word lines is electrically connected to one of the plurality of lower transistors and one of the plurality of upper transistors, which at least partially overlap each other in the vertical direction, and each of the plurality of bit lines is electrically connected to one other of the plurality of lower transistors and one other of the plurality of upper transistors, which at least partially overlap each other in the vertical direction.

According to some implementations, there is provided a semiconductor memory device including a lower peripheral circuit structure including a lower semiconductor substrate, and a plurality of lower local word line selection transistors and a plurality of lower local bit line selection transistors, which are arranged on the lower semiconductor substrate, an upper peripheral circuit structure provided above the lower peripheral circuit structure and including an upper semiconductor substrate, and a plurality of upper local word line selection transistors and a plurality of upper local bit line selection transistors, which are arranged on the upper semiconductor substrate, a memory cell structure provided on the upper peripheral circuit structure and including a plurality of word lines extending in a first horizontal direction, a plurality of bit lines provided at a different vertical level from the plurality of word lines and extending in a second horizontal direction that is different from the first horizontal direction, a plurality of selectors arranged between the plurality of word lines and the plurality of bit lines to constitute a plurality of memory cells, and an interlayer insulating layer surrounding the plurality of word lines, the plurality of bit lines, and the plurality of memory cells, a lower wiring structure provided below the lower peripheral circuit structure and including a lower cover insulating layer and a plurality of lower contact plugs passing through the lower cover insulating layer and electrically connected to the lower peripheral circuit structure, an upper wiring structure provided above the memory cell structure and including an upper cover insulating layer and a plurality of upper contact plugs passing through the upper cover insulating layer and electrically connected to the upper peripheral circuit structure, and a plurality of vertical through-electrodes configured to electrically connect the lower peripheral circuit structure to the upper peripheral circuit structure, wherein each of the plurality of word lines is electrically connected to one of the plurality of lower local word line selection transistors and one of the plurality of upper local word line selection transistors, which at least partially overlap each other in a vertical direction, and each of the plurality of bit lines is electrically connected to one of the plurality of lower local bit line selection transistors and one of the plurality of upper local bit line selection transistors, which at least partially overlap each other in the vertical direction.

According to some implementations, there is provided a semiconductor memory device including a lower peripheral circuit structure including a lower semiconductor substrate, a plurality of lower local word line selection transistors and a plurality of lower local bit line selection transistors, which are arranged on the lower semiconductor substrate, a plurality of lower wiring lines, a plurality of lower wiring contacts configured to electrically connect the plurality of lower wiring lines to the plurality of lower local word line selection transistors and the plurality of lower local bit line selection transistors, and a lower wiring insulating layer surrounding the plurality of lower wiring lines and the plurality of lower wiring contacts, an upper peripheral circuit structure provided above the lower peripheral circuit structure and including an upper semiconductor substrate, a plurality of upper local word line selection transistors and a plurality of upper local bit line selection transistors, which are arranged on the upper semiconductor substrate, a plurality of upper wiring lines, a plurality of upper wiring contacts configured to electrically connect the plurality of upper wiring lines to the plurality of the upper local word line selection transistors and the plurality of upper local bit line selection transistors, and an upper wiring insulating layer surrounding the plurality of upper wiring lines and the plurality of upper wiring contacts, a memory cell structure provided above the upper peripheral circuit structure and including a plurality of word lines extending in a first horizontal direction, a plurality of bit lines provided above the plurality of word lines and extending in a second horizontal direction that is different from the first horizontal direction, a plurality of selectors located between the plurality of word lines and the plurality of bit lines, a plurality of word line contacts configured to connect the plurality of word lines to the plurality of upper wiring lines, a plurality of bit line contacts configured to connect the plurality of bit lines to the plurality of upper wiring lines, and an interlayer insulating layer surrounding the plurality of word line contacts, the plurality of bit line contacts, the plurality of word lines, the plurality of bit lines, and the plurality of selectors, wherein each of the plurality of selectors includes a selection material layer, a first selection electrode layer located between the selection material layer and each of the plurality of bit lines, and a second selection electrode layer located between each of the plurality of word lines and the selection material layer, a lower wiring structure provided below the lower peripheral circuit structure and including a lower cover insulating layer and a plurality of lower contact plugs passing through the lower cover insulating layer and electrically connected to the plurality of lower wiring lines, an upper wiring structure provided above the memory cell structure and including an upper cover insulating layer and a plurality of upper contact plugs passing through the upper cover insulating layer and electrically connected to the plurality of upper wiring lines, and a plurality of vertical through-electrodes passing through the lower wiring insulating layer, the lower semiconductor substrate, the upper semiconductor substrate, and the upper wiring insulating layer and configured to connect the plurality of lower wiring lines to the plurality of upper wiring lines, wherein each of the plurality of word lines is electrically connected to one of the plurality of lower local word line selection transistors and one of the plurality of upper local word line selection transistors, which at least partially overlap each other in a vertical direction, and each of the plurality of bit lines is electrically connected to one of the plurality of lower local bit line selection transistors and one of the plurality of upper local bit line selection transistors, which at least partially overlap each other in the vertical direction.

At least some of the above and other features of the invention are set out in the claims.

### BRIEF DESCRIPTION OF THE DRAWINGS

Implementations will be more clearly understood from the following detailed description taken in conjunction with the accompanying drawings.
FIG. 1 is an equivalent circuit diagram showing a semiconductor memory device according to implementations.
FIGS. 2A and 2B are conceptual diagrams illustrating a semiconductor memory device according to implementations.
FIG. 3 is a cross-sectional view of a semiconductor memory device according to implementations.
FIGS. 4A to 4F are cross-sectional views illustrating a method of manufacturing a semiconductor memory device, according to implementations.
FIG. 5 is a cross-sectional view of a semiconductor memory device according to implementations.
FIGS. 6 and 7 are cross-sectional views of semiconductor memory devices according to implementations.
FIG. 8 is a conceptual diagram illustrating a semiconductor memory device according to implementations.
FIGS. 9A and 9B are cross-sectional views of a semiconductor memory device according to implementations.
FIGS. 10A and 10B are cross-sectional views of a semiconductor memory device according to implementations.
FIGS. 11A and 11B are cross-sectional views of a semiconductor memory device according to implementations.
FIGS. 12A and 12B are cross-sectional views of a semiconductor memory device according to implementations.

### DETAILED DESCRIPTION

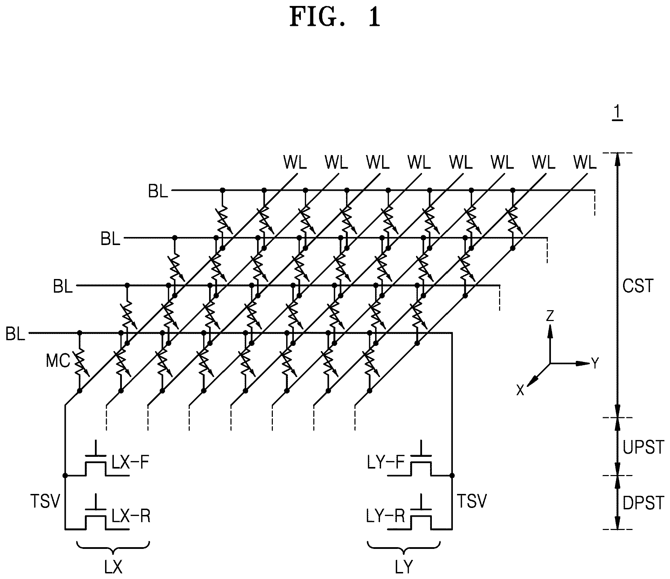

FIG. 1 is an equivalent circuit diagram showing a semiconductor memory device 1 according to implementations.

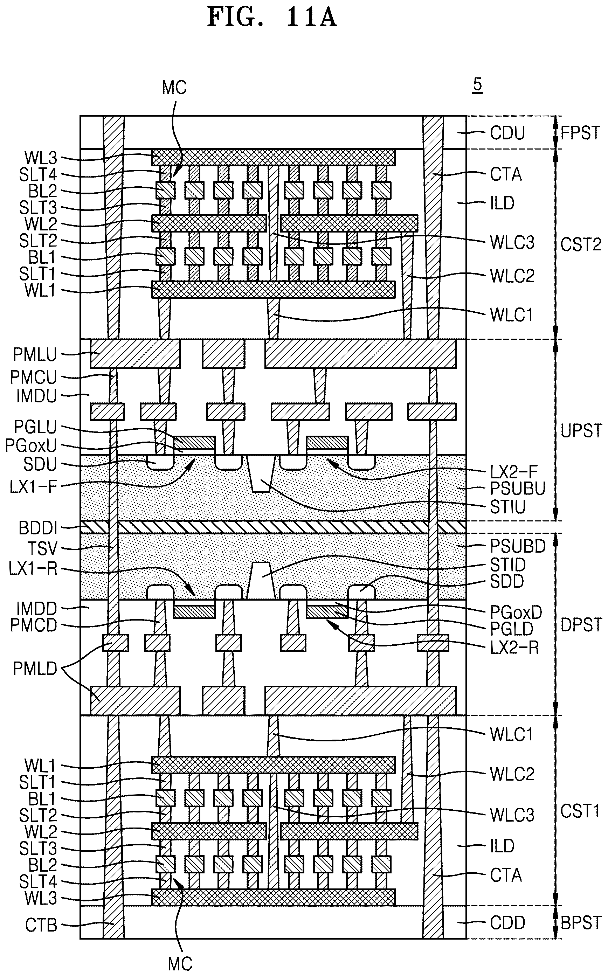

Referring to FIG. 1, the semiconductor memory device 1 includes a memory cell structure CST, an upper peripheral circuit structure UPST, and a lower peripheral circuit structure DPST, which are stacked in a vertical direction (a Z direction). The upper peripheral circuit structure UPST is disposed on the lower peripheral circuit structure DPST. The memory cell structure CST may be disposed above the upper peripheral circuit structure UPST, but implementations are not limited thereto. In some implementations, the memory cell structure CST may be disposed above the lower peripheral circuit structure DPST and the upper peripheral circuit structure UPST. In some implementations, the memory cell structure CST may be located between the lower peripheral circuit structure DPST and the upper peripheral circuit structure UPST. In some implementations, the memory cell structure CST may include a first memory cell structure CST1 and a second memory cell structure CST2 disposed above the first memory cell structure CST1, as shown in FIGS. 11A to 12B. In some implementations, the first memory cell structure CST1 may be disposed below the lower peripheral circuit structure DPST, and the second memory cell structure CST2 may be disposed above the upper peripheral circuit structure UPST. For example, the lower peripheral circuit structure DPST and the upper peripheral circuit structure UPST may be arranged between the first memory cell structure CST1 and the second memory cell structure CST2. In some implementations, the first memory cell structure CST1 may be disposed above the lower peripheral circuit structure DPST, and the second memory cell structure CST2 may be disposed above the upper peripheral circuit structure UPST. The vertical direction (the Z direction) may define a height direction of the semiconductor memory device 1. The terms "upper", "middle", "lower", "above", "below", etc. may refer to relative positions along a vertical direction (the Z direction). It will be appreciated that the directions and positions discussed herein are defined relative to the structure of the semiconductor memory device 1, and therefore need not limit the semiconductor memory device 1 to any particular orientation in use.

The lower peripheral circuit structure DPST may include a plurality of lower transistors and the upper peripheral circuit structure UPST may include a plurality of upper transistors. The plurality of lower transistors and the plurality of upper transistors may operate in directions opposite to each other (e.g., may have opposite polarities). The plurality of lower transistors may include a lower local word line selection transistor LX-R and a lower local bit line selection transistor LY-R, and the plurality of upper transistors may include an upper local word line selection transistor LX-F and an upper local bit line selection transistor LY-F.

The memory cell structure CST may include a plurality of word lines WL, a plurality of bit lines BL, and a plurality of memory cells MC arranged between the plurality of word lines WL and the plurality of bit lines BL. A plurality of local word line selection transistors LX may be respectively connected to the plurality of word lines WL, and a plurality of local bit line selection transistors LY may be respectively connected to the plurality of bit lines BL. The plurality of local word line selection transistors LX includes the upper local word line selection transistors LX-F and the lower local word line selection transistors LX-R, and the plurality of local bit line selection transistors LY includes the upper local bit line selection transistors LY-F and the lower local bit line selection transistors LY-R.

The lower peripheral circuit structure DPST may be electrically connected to the upper peripheral circuit structure UPST via a plurality of vertical through-electrodes TSV (e.g., through-silicon vias). For example, a lower local word line selection transistor LX-R and an upper local word line selection transistor LX-F, which are connected to one word line WL, may be electrically connected to each other via a vertical through-electrode TSV. For example, a lower local bit line selection transistor LY-R and an upper local bit line selection transistor LY-F, which are connected to one bit line BL, may be electrically connected to each other via a vertical through-electrode TSV.

One lower local word line selection transistor LX-R and one upper local word line selection transistor LX-F may be connected to one word line WL, and one lower local bit line selection transistor LY-R and one upper local bit line selection transistor LY-F may be connected to one bit line BL. In some implementations, the lower local word line selection transistor LX-R and the upper local word line selection transistor LX-F, which are connected to one word line WL, may at least partially overlap each other in the vertical direction (the Z direction). In some implementations, the lower local bit line selection transistor LY-R and the upper local bit line selection transistor LY-F, which are connected to one bit line BL, may at least partially overlap each other in the vertical direction (the Z direction). The lower local word line selection transistor LX-R and the upper local word line selection transistor LX-F may provide forward and reverse local word line selection signals to the word line WL, and the lower local bit line selection transistor LY-R and the upper local bit line selection transistor LY-F may provide forward and reverse local bit line selection signals to the bit line BL. Two components may at least partially overlap each other in a particular direction if they are positioned such that a line that runs in the particular direction may be positioned such that it passes through at least a portion of each component. For instance, components or layers described as "overlapping" in a particular direction may be at least partially obstructed by one another when viewed along a line extending in the particular direction.

The plurality of word lines WL may extend in a first horizontal direction (an X direction) and be spaced apart from each other in a second horizontal direction (a Y direction) that is different from the first horizontal direction (the X direction). The first horizontal direction (the X direction) may be perpendicular to the second horizontal direction (the Y direction). The first horizontal direction (the X direction) and the second horizontal direction (the Y direction) may cross (e.g., may be perpendicular to) the vertical direction (the Z direction). In some implementations, the plurality of word lines WL may be spaced apart from each other by equal intervals in the second horizontal direction (the Y direction). The plurality of bit lines BL may extend in the second horizontal direction (the Y direction) and be spaced apart from each other in the first horizontal direction (the X direction). In some implementations, the plurality of bit lines BL may be spaced apart from each other by equal intervals in the first horizontal direction (the X direction). In some implementations, the plurality of bit lines BL may be disposed above the plurality of word lines WL. The plurality of memory cells MC may be arranged between the plurality of bit lines BL and the plurality of word lines WL, which intersect each other when viewed in the vertical direction (the Z direction). For example, the plurality of memory cells MC may be arranged in a matrix form in a plan view.

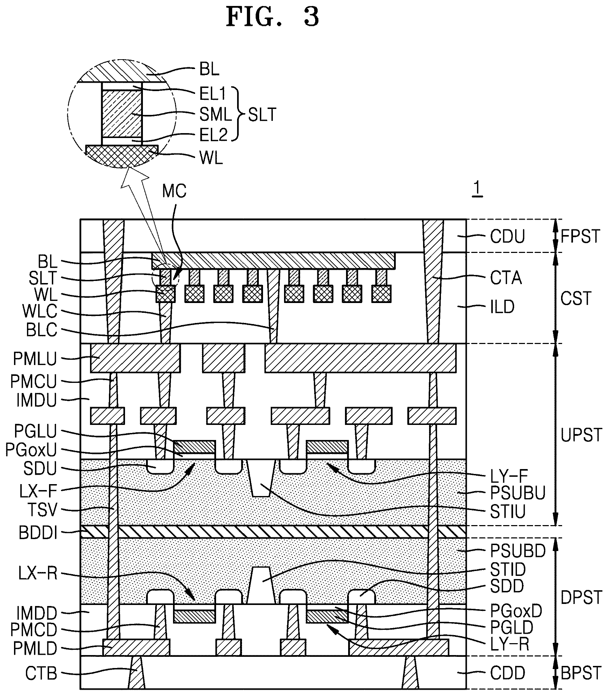

In some implementations, each of the plurality of memory cells MC may include a selector SLT (FIG. 3). For example, the semiconductor memory device 1 may include selector-only memory (SOM) or self-selecting memory (SSM). In some implementations, the selector SLT (FIG. 3) may include a first selection electrode layer, a selection material layer, and a second selection electrode layer. The first selection electrode layer may be located between the bit line BL and the selection material layer, and the second selection electrode layer may be located between the word line WL and the selection material layer. Each of the plurality of memory cells MC may store data by distinguishing '0' or '1' according to a threshold voltage that changes due to bidirectional write operations. Each of the plurality of memory cells MC may be located between the bit line BL and the word line WL and bidirectionally operated by the lower local word line selection transistor LX-R and the upper local word line selection transistor LX-F, which are connected to the word line WL, and the lower local bit line selection transistor LY-R and the upper local bit line selection transistor LY-F, which are connected to the bit line BL. For example, the lower local word line selection transistor LX-R and the upper local word line selection transistor LX-F, which are connected to the word line WL, may operate in directions opposite to each other, and the lower local bit line selection transistor LY-R and the upper local bit line selection transistor LY-F, which are connected to the bit line BL, may operate in directions opposite to each other. In the present context, two transistors that "operate in opposite directions" may control current flow for different (e.g., opposite) voltage polarities (e.g., positive and negative). For instance, the corresponding upper and lower selection transistors may control current in opposite directions to each other.

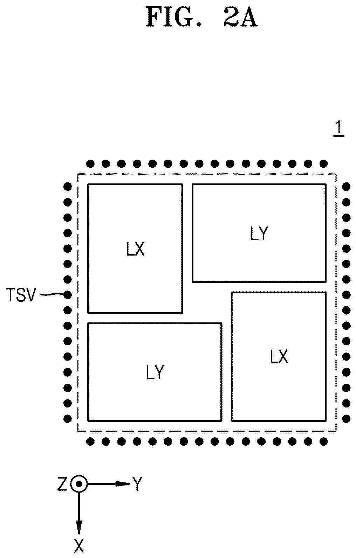

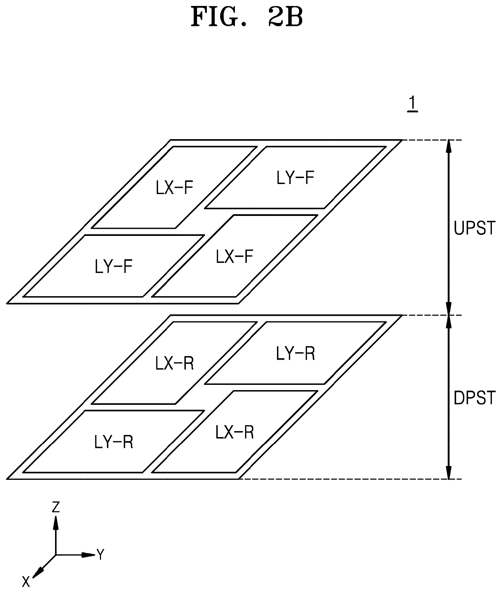

Even if coordinate axes are not illustrated in the diagrams in this specification, a direction in which one word line WL extends may represent the first horizontal direction (the X direction), and a direction in which one bit line BL extends may represent the second horizontal direction (the Y direction), unless otherwise stated. Also, the diagram only shows the arrangement, in the vertical direction (the Z direction), the plurality of local word line selection transistors LX, each including the lower local word line selection transistor LX-R and the upper local word line selection transistor LX-F, and the plurality of local bit line selection transistors LY, each including the lower local bit line selection transistor LY-R and the upper local bit line selection transistor LY-F, but does not limit the arrangement thereof in the horizontal direction, for example, the first horizontal direction (the X direction) and/or the second horizontal direction (the Y direction). For example, FIGS. 2A and 2B each illustrate an example of the planar arrangement of the plurality of local word line selection transistors LX, each including the lower local word line selection transistor LX-R and the upper local word line selection transistor LX-F, and the plurality of local bit line selection transistors LY, each including the lower local bit line selection transistor LY-R and the upper local bit line selection transistor LY-F. However, for example, FIGS. 1 and 3 only illustrate the arrangement, in the vertical direction (the Z direction), of the lower local word line selection transistor LX-R, the upper local word line selection transistor LX-F, the lower local bit line selection transistor LY-R, and the upper local bit line selection transistor LY-F, but do not limit the arrangement thereof in the first horizontal direction (the X direction) and/or the second horizontal direction (the Y direction).

In the semiconductor memory device 1 for bidirectional operation of each of the plurality of memory cells MC, the word line WL may be connected to the lower local word line selection transistor LX-R and the upper local word line selection transistor LX-F, and the bit line BL may be connected to the lower local bit line selection transistor LY-R and the upper local bit line selection transistor LY-F. The upper peripheral circuit structure UPST, which includes the upper local word line selection transistor LX-F and the upper local bit line selection transistor LY-F, may be disposed on the lower peripheral circuit structure DPST, which includes the lower local word line selection transistor LX-R and the lower local bit line selection transistor LY-R. Therefore, the area of the semiconductor memory device 1 may decrease or the degree of integration thereof may increase based on the same area. In addition, the lower local word line selection transistor LX-R and the upper local word line selection transistor LX-F, and the lower local bit line selection transistor LY-R and the upper local bit line selection transistor LY-F are electrically connected to each other via the plurality of vertical through-electrodes TSV. Therefore, the electrical paths therebetween may be shortened, which may improve the operating performance of the semiconductor memory device 1.

FIGS. 2A and 2B are conceptual diagrams illustrating the semiconductor memory device 1 according to implementations.

Referring to FIGS. 2A and 2B together, the semiconductor memory device 1 may include regions, in which the plurality of local word line selection transistors LX are arranged, and regions, in which the plurality of local bit line selection transistors LY are arranged. The regions, in which the plurality of local word line selection transistors LX are arranged, and the regions, in which the plurality of local bit line selection transistors LY are arranged, may each be referred to as a tile. The regions, in which the plurality of local word line selection transistors LX are arranged, and the regions, in which the plurality of local bit line selection transistors LY are arranged, may be alternately arranged in both the first horizontal direction (the X direction) and the second horizontal direction (the Y direction). In some implementations, each of the regions, in which the plurality of local word line selection transistors LX are arranged, may have a rectangular shape having a long side in the first horizontal direction (the X direction) and a short side in the second horizontal direction (the Y direction) in a plan view. For example, each of the regions, in which the plurality of local word line selection transistors LX are arranged, may have a rectangular shape having a long side in the first horizontal direction (the X direction), i.e., the direction in which the word line WL (FIG. 1) extends, in a plan view. In some implementations, each of the regions, in which the plurality of local bit line selection transistors LY are arranged, may have a rectangular shape having a long side in the second horizontal direction (the Y direction) and a short side in the first horizontal direction (the X direction), in a plan view. For example, each of the regions, in which the plurality of local bit line selection transistors LY are arranged, may have a rectangular shape having a long side in the second horizontal direction (the Y direction), i.e., the direction in which the bit line BL (FIG. 1) extends, in a plan view.

The plurality of vertical through-electrodes TSV may surround the regions, in which the plurality of local word line selection transistors LX are arranged, and the regions, in which the plurality of local bit line selection transistors LY are arranged. For example, some of the plurality of vertical through-electrodes TSV may be arranged in a row in the first horizontal direction (the X direction), and the other vertical through-electrodes TSV may be arranged in a row in the second horizontal direction (the Y direction).

Each of the regions in which the plurality of local word line selection transistors LX are arranged may include a region, in which the upper local word line selection transistor LX-F is located, and a region, in which the lower local word line selection transistor LX-R is located. In each of the regions in which the plurality of local word line selection transistors LX are arranged, the region in which the upper local word line selection transistor LX-F is located may overlap, in the vertical direction (the Z direction), the region in which the lower local word line selection transistor LX-R is located. Each of the regions in which the plurality of local bit line selection transistors LY are arranged may include a region, in which the upper local bit line selection transistor LY-F is located, and a region, in which the lower local bit line selection transistor LY-R is located. In each of the regions in which the plurality of local bit line selection transistors LY are arranged, the region in which the upper local bit line selection transistor LY-F is located may overlap, in the vertical direction (the Z direction), the region in which the lower local bit line selection transistor LY-R is located.

The semiconductor memory device 1 may include the upper peripheral circuit structure UPST and the lower peripheral circuit structure DPST. The region in which the upper local word line selection transistor LX-F is located and the region in which the upper local bit line selection transistor LY-F is located may be arranged in the upper peripheral circuit structure UPST. Also, the region in which the lower local word line selection transistor LX-R is located and the region in which the lower local bit line selection transistor LY-R is located may be arranged in the lower peripheral circuit structure DPST. The upper peripheral circuit structure UPST may be located on the lower peripheral circuit structure DPST.

FIG. 3 is a cross-sectional view of the semiconductor memory device 1 according to implementations.

Referring to FIG. 3, the semiconductor memory device 1 may include the lower peripheral circuit structure DPST, the upper peripheral circuit structure UPST, and the memory cell structure CST, which are sequentially stacked in the vertical direction. A bonding structure BDDI may be located between the lower peripheral circuit structure DPST and the upper peripheral circuit structure UPST. A lower wiring structure BPST may be disposed below the lower peripheral circuit structure DPST, and an upper wiring structure FPST may be disposed on the memory cell structure CST. The lower wiring structure BPST, the lower peripheral circuit structure DPST, the bonding structure BDDI, the upper peripheral circuit structure UPST, the memory cell structure CST, and the upper wiring structure FPST may overlap each other in the vertical direction. The lower peripheral circuit structure DPST may be electrically connected to the upper peripheral circuit structure UPST via the plurality of vertical through-electrodes TSV.

The lower peripheral circuit structure DPST includes a lower semiconductor substrate PSUBD, a lower device isolation layer STID, a plurality of lower transistors, a plurality of lower wiring lines PMLD and a plurality of lower wiring contacts PMCD, which are electrically connected to the plurality of lower transistors, and a lower wiring insulating layer IMDD that surrounds the plurality of lower transistors, the plurality of lower wiring lines PMLD, and the plurality of lower wiring contacts PMCD. The plurality of lower transistors may include the lower local word line selection transistor LX-R and the lower local bit line selection transistor LY-R. The lower device isolation layer STID may be buried in the lower semiconductor substrate PSUBD. In some implementations, the lower device isolation layer STID may be buried in the lower semiconductor substrate PSUBD, extending from the lower surface of the lower semiconductor substrate PSUBD into the lower semiconductor substrate PSUBD. The lower local word line selection transistor LX-R and the lower local bit line selection transistor LY-R may each be located in a region of the lower semiconductor substrate PSUBD, which is defined by the lower device isolation layer STID. In some implementations, the lower local word line selection transistor LX-R and the lower local bit line selection transistor LY-R may each be located in a lower region of the lower semiconductor substrate PSUBD.

The lower local word line selection transistor LX-R and the lower local bit line selection transistor LY-R may each include a lower gate electrode PGLD, a lower gate dielectric layer PGoxD, and a lower source-drain region SDD. The plurality of lower wiring contacts PMCD may be arranged between the lower local word line selection transistor LX-R and the lower local bit line selection transistor LY-R, and the plurality of lower wiring lines PMLD. FIG. 3 illustrates that the plurality of lower wiring contacts PMCD connect the plurality of lower wiring lines PMLD to the plurality of lower source-drain regions SDD, but this is only an example and implementations are not limited thereto. For example, the plurality of lower wiring contacts PMCD may connect the plurality of lower wiring lines PMLD to the lower gate electrode PGLD. The lower wiring insulating layer IMDD may cover the lower surface of the lower semiconductor substrate PSUBD and surround the plurality of lower transistors (e.g., the plurality of lower gate electrodes PGLD, the plurality of lower gate dielectric layers PGoxD), the plurality of lower wiring contacts PMCD, and the plurality of lower wiring lines PMLD. The lower source-drain region SDD may be formed by implanting impurities into a lower region of the lower semiconductor substrate PSUBD. For example, when the lower semiconductor substrate PSUBD is of a first conductivity type, the lower source-drain region SDD may be of a second conductivity type that is different from the first conductivity type. In some implementations, the first conductivity type may represent a p-type and the second conductivity type may represent an n-type, but implementations are not limited thereto. For example, the first conductivity type may represent the n-type and the second conductivity type may represent the p-type.

The upper peripheral circuit structure UPST includes an upper semiconductor substrate PSUBU, an upper device isolation layer STIU, a plurality of upper transistors, a plurality of upper wiring lines PMLU and a plurality of upper wiring contacts PMCU, which are electrically connected to the plurality of upper transistors, and an upper wiring insulating layer IMDU that surrounds the plurality of upper transistors, the plurality of upper wiring lines PMLU, and the plurality of upper wiring contacts PMCU. The plurality of upper transistors include the upper local word line selection transistor LX-F and the upper local bit line selection transistor LY-F. The upper device isolation layer STIU may be buried in the upper semiconductor substrate PSUBU. In some implementations, the upper device isolation layer STIU may be buried in the upper semiconductor substrate PSUBU, extending from the upper surface of the upper semiconductor substrate PSUBU into the upper semiconductor substrate PSUBU. The upper local word line selection transistor LX-F and the upper local bit line selection transistor LY-F may each be located in a region of the upper semiconductor substrate PSUBU, which is defined by the upper device isolation layer STIU. In some implementations, the upper local word line selection transistor LX-F and the upper local bit line selection transistor LY-F may each be located in an upper region of the upper semiconductor substrate PSUBU.

The upper local word line selection transistor LX-F and the upper local bit line selection transistor LY-F may each include an upper gate electrode PGLU, an upper gate dielectric layer PGoxU, and an upper source-drain region SDU. The plurality of upper wiring contacts PMCU may be arranged between the upper local word line selection transistor LX-F and the upper local bit line selection transistor LY-F, and the plurality of upper wiring lines PMLU. FIG. 3 illustrates that the plurality of upper wiring contacts PMCU connect the plurality of upper wiring lines PMLU to the plurality of upper source-drain regions SDU, but this is only an example and implementations are not limited thereto. For example, the plurality of upper wiring contacts PMCU may connect the plurality of upper wiring lines PMLU to the upper gate electrode PGLU. The upper wiring insulating layer IMDU may cover the upper surface of the upper semiconductor substrate PSUBU and surround the plurality of upper transistors (e.g., the plurality of upper gate electrodes PGLU, the plurality of upper gate dielectric layers PGoxU), the plurality of upper wiring contacts PMCU, and the plurality of upper wiring lines PMLU. The upper source-drain region SDU may be formed by implanting impurities into an upper region of the upper semiconductor substrate PSUBU. For example, when the upper semiconductor substrate PSUBU is of a first conductivity type, the upper source-drain region SDU may be of a second conductivity type that is different from the first conductivity type.

Each of the lower semiconductor substrate PSUBD and the upper semiconductor substrate PSUBU may include, for example, semiconductor materials, such as a group IV semiconductor material, a group III-V semiconductor material or a group II-VI semiconductor material, and a group II-VI oxide semiconductor material. The group IV semiconductor material may include, for example, silicon (Si), germanium (Ge), or silicon-germanium (Si-Ge). The group III-V semiconductor material may include, for example, gallium arsenide (GaAs), indium phosphide (InP), gallium phosphide (GaP), indium arsenide (InAs), indium antimonide (InSb), or indium gallium arsenide (InGaAs). The group II-VI semiconductor material may include, for example, zinc telluride (ZnTe) or cadmium sulfide (CdS). The lower semiconductor substrate PSUBD and the upper semiconductor substrate PSUBU may each be provided as a bulk wafer or as an epitaxial layer. In other implementations, the lower semiconductor substrate PSUBD and the upper semiconductor substrate PSUBU may each include a silicon-on-insulator (SOI) substrate or a germanium-on-insulator (GeOI) substrate.

The lower gate dielectric layer PGoxD and the upper gate dielectric layer PGoxU may each include a silicon oxide layer, a high-k dielectric layer, or a combination thereof. In some implementations, the lower gate dielectric layer PGoxD and the upper gate dielectric layer PGoxU may each have a stack structure of an interfacial layer and a high-k dielectric layer. The interfacial layer may include a low-k material having a dielectric constant of about 9 or less. For example, the interfacial layer may include oxide, nitride, or oxynitride. The high-k dielectric layer may include metal oxide or metal oxynitride. The high-k dielectric layer may include a material having a higher dielectric constant than the silicon oxide layer. For example, the high-k dielectric layer may have a dielectric constant of about 10 to about 25. The high-k dielectric layer may have a thickness of about 10 Å to about 40 Å, but implementations are not limited thereto. In some implementations, the interfacial layer may be omitted. For example, the lower gate dielectric layer PGoxD and the upper gate dielectric layer PGoxU may each include HfO₂, Al₂O₃, HfAlO₃, Ta₂O₃, or TiO₂.

The lower gate electrode PGLD and the upper gate electrode PGLU may each include a work function control metal-containing layer and a gap-fill metal-containing layer that fills an upper space of the work function control metal-containing layer. The work function control metal-containing layer may include at least one metal selected from a group consisting of Ti, W, Ru, Nb, Mo, Hf, Ni, Co, Pt, Yb, Tb, Dy, Er, and Pd. In some implementations, the lower gate electrode PGLD and the upper gate electrode PGLU may each have a structure in which a metal nitride layer, a metal layer, a conductive capping layer, and a gap-fill metal layer are sequentially stacked. The metal nitride layer and the metal layer may include at least one metal selected from a group consisting of Ti, Ta, W, Ru, Nb, Mo, and Hf. The gap-fill metal layer may include a W layer or an Al layer. In some implementations, the lower gate electrode PGLD and the upper gate electrode PGLU may each have a stack structure of TiAlC/TiN/W, a stack structure of TiN/TaN/TiAlC/TiN/W, or a stack structure of TiN/TaN/TiN/TiAlC/TiN/W, but implementations are not limited to the examples described above.

The plurality of lower wiring contacts PMCD, the plurality of lower wiring lines PMLD, the plurality of upper wiring lines PMLU, and the plurality of upper wiring contacts PMCU may each include a conductive material, such as copper (Cu), aluminum (Al), tungsten (W), silver (Ag), and gold (Au), or a combination thereof. The lower wiring insulating layer IMDD and the upper wiring insulating layer IMDU may each include an insulating material that may include silicon oxide, silicon nitride, a low-k material, or a combination thereof. The low-k material may have a lower dielectric constant than silicon oxide and include, for example, phosphosilicate glass (PSG), borophosphosilicate glass (BPSG), fluorosilicate glass (FSG), organosilicate glass (OSG), spin-on-glass (SOG), spin-on-polymer, or a combination thereof. In some implementations, the lower wiring insulating layer IMDD and the upper wiring insulating layer IMDU may each include an ultra-low k (ULK) material having an ultralow dielectric constant K of about 2.2 to about 2.4. The ULK material may include SiOC or SiCOH.

In some implementations, the lower local word line selection transistor LX-R and the upper local word line selection transistor LX-F, which are connected to one word line WL, may overlap each other in the vertical direction, but implementations are not limited thereto. For example, the lower local word line selection transistor LX-R and the upper local word line selection transistor LX-F, which are connected to one word line WL, may at least partially overlap each other in the vertical direction. In some implementations, the lower local bit line selection transistor LY-R and the upper local bit line selection transistor LY-F, which are connected to one bit line BL, may overlap each other in the vertical direction, but implementations are not limited thereto. For example, the lower local bit line selection transistor LY-R and the upper local bit line selection transistor LY-F, which are connected to one bit line BL, may at least partially overlap each other in the vertical direction.

The bonding structure BDDI may be located between the upper surface of the lower semiconductor substrate PSUBD and the lower surface of the upper semiconductor substrate PSUBU. The bonding structure BDDI may include an insulating material. In some implementations, the bonding structure BDDI may be formed by a covalent bond between a lower bonding insulating layer covering the top of the lower peripheral circuit structure DPST and an upper bonding insulating layer covering the bottom of the upper peripheral circuit structure UPST. The bonding structure BDDI may include silicon oxide or silicon carbonitride (SiCN). For example, each of the lower bonding insulating layer and the upper bonding insulating layer may include silicon oxide or silicon carbonitride (SiCN). The plurality of vertical through-electrodes TSV may pass through the bonding structure BDDI to electrically connect the lower peripheral circuit structure DPST to the upper peripheral circuit structure UPST.

In some implementations, the lower peripheral circuit structure DPST and the upper peripheral circuit structure UPST may be bonded to each other by a metal-oxide hybrid bonding method and thus be electrically connected to each other. For example, the bonding structure BDDI may include a plurality of bonding pads and a bonding insulating layer surrounding the plurality of bonding pads. The plurality of bonding pads may electrically connect parts of the plurality of vertical through-electrodes TSV at least partially passing through the lower peripheral circuit structure DPST to parts of the plurality of vertical through-electrodes TSV at least partially passing through the upper peripheral circuit structure UPST, thereby electrically connecting the lower peripheral circuit structure DPST to the upper peripheral circuit structure UPST. The bonding insulating layer may be formed by the covalent bond between the lower bonding insulating layer covering the top of the lower peripheral circuit structure DPST and the upper bonding insulating layer covering the bottom of the upper peripheral circuit structure UPST. For example, the bonding insulating layer may include silicon oxide or silicon carbonitride (SiCN). Each of the plurality of bonding pads may be formed by bonding a lower bonding pad surrounded by the lower bonding insulating layer to an upper bonding pad surrounded by the upper bonding insulating layer. For example, the lower bonding pad and the upper bonding pad corresponding thereto may be expanded by heat, brought into contact with each other, and then integrated with each other by diffusion of metal atoms contained therein. Accodingly, the diffusion-bonded bonding pad may be formed.

In some implementations, the upper local word line selection transistor LX-F, the upper local bit line selection transistor LY-F, the lower local word line selection transistor LX-R, and the lower local bit line selection transistor LY-R may be arranged on the opposite sides of the upper semiconductor substrate PSUBU and the lower semiconductor substrate PSUBD. For example, the upper peripheral circuit structure UPST may have a face-up structure in which the upper local word line selection transistor LX-F and the upper local bit line selection transistor LY-F are located on the upper side of the upper semiconductor substrate PSUBU, which faces the memory cell structure CST. The lower peripheral circuit structure DPST may have a face-down structure in which the lower local word line selection transistor LX-R and the lower local bit line selection transistor LY-R are located on the lower side of the lower semiconductor substrate PSUBD, which faces the lower wiring structure BPST on the opposite side to the memory cell structure CST.

The memory cell structure CST includes the plurality of word lines WL extending in the first horizontal direction, the plurality of bit lines BL extending in the second horizontal direction, a plurality of selectors SLT located between the plurality of word lines WL and the plurality of bit lines BL, and an interlayer insulating layer ILD that surrounds the plurality of word lines WL, the plurality of bit lines BL, and the plurality of selectors SLT. The plurality of selectors SLT may constitute the plurality of memory cells MC. Each of the plurality of word lines WL may include a conductive material. For example, each of the plurality of word lines WL may include doped polysilicon, metal, conductive metal nitride, or a combination thereof. Each of the plurality of bit lines BL may include a conductive material. For example, each of the plurality of bit lines BL may include doped polysilicon, metal, conductive metal nitride, or a combination thereof. The interlayer insulating layer ILD may include silicon oxide or an insulating material having a lower dielectric constant than silicon oxide. In some implementations, the interlayer insulating layer ILD may include tetraethyl orthosilicate (TEOS) or a ULK material.

In some implementations, the selector SLT may include a first selection electrode layer EL1, a selection material layer SML, and a second selection electrode layer EL2. The first selection electrode layer EL1 may be located between the bit line BL and the selection material layer SML, and the second selection electrode layer EL2 may be located between the word line WL and the selection material layer SML.

The first selection electrode layer EL1 and the second selection electrode layer EL2 may each include a conductive material. For example, the first selection electrode layer EL1 and the second selection electrode layer EL2 may each include carbon or a conductive material containing carbon. The selection material layer SML may include a material having ovonic threshold switching (OTS) characteristics. The selection material layer SML may include a chalcogenide material. For example, the selection material layer SML may be formed as a single layer or a multilayer that includes a material selected from a group consisting of two-component materials, three-component materials, four-component materials, five-component materials, and six-component materials. Here, the two-component materials may include GeSe, GeS, AsSe, AsTe, AsS, SiTe, SiSe, SiS, GeAs, SiAs, SnSe, and/or SnTe. The three-component materials may include GeAsTe, GeAsSe, AlAsTe, AlAsSe, SiAsSe, SiAsTe, GeSeTe, GeSeSb, GaAsSe, GaAsTe, InAsSe, InAsTe, SnAsSe, and/or SnAsTe. The four-component materials may include GeSiAsTe, GeSiAsSe, GeSiSeTe, GeSeTeSb, GeSiSeSb, GeSiTeSb, GeSeTeBi, GeSiSeBi, GeSiTeBi, GeAsSeSb, GeAsTeSb, GeAsTeBi, GeAsSeBi, GeAsSeIn, GeAsSeGa, GeAsSeAl, GeAsSeTl, GeAsSeSn, GeAsSeZn, GeAsTeIn, GeAsTeGa, GeAsTeAl, GeAsTeTl, GeAsTeSn, and/or GeAsTeZn. The five-component materials may include GeSiAsSeTe, GeAsSeTeS, GeSiAsSeS, GeSiAsTeS, GeSiSeTeS, GeSiAsSeP, GeSiAsTeP, GeAsSeTeP, GeSiAsSeIn, GeSiAsSeGa, GeSiAsSeAl, GeSiAsSeTl, GeSiAsSeZn, GeSiAsSeSn, GeSiAsTeIn, GeSiAsTeGa, GeSiAsTeAl, GeSiAsTeTl, GeSiAsTeZn, GeSiAsTeSn, GeAsSeTeIn, GeAsSeTeGa, GeAsSeTeAl, GeAsSeTeTl, GeAsSeTeZn, GeAsSeTeSn, GeAsSeSIn, GeAsSeSGa, GeAsSeSAl, GeAsSeSTl, GeAsSeSZn, GeAsSeSSn, GeAsTeSIn, GeAsTeSGa, GeAsTeSAl, GeAsTeSTl, GeAsTeSZn, GeAsTeSSn, GeAsSeInGa, GeAsSeInAl, GeAsSeInTl, GeAsSeInZn, GeAsSeInSn, GeAsSeGaAl, GeAsSeGaTl, GeAsSeGaZn, GeAsSeGaSn, GeAsSeAlTl, GeAsSeAlZn, GeAsSEAlSn, GeAsSeTlZn, GeAsSeTlSn, and/or GeAsSeZnSn. The six-component materials may include GeSiAsSeTeS, GeSiAsSeTeIn, GeSiAsSeTeGa, GeSiAsSeTeAl, GeSiAsSeTeTl, GeSiAsSeTeZn, GeSiAsSeTeSn, GeSiAsSeTeP, GeSiAsSeSIn, GeSiAsSeSGa, GeSiAsSeSAl, GeSiAsSeSTl, GeSiAsSeSZn, GeSiAsSeSSn, GeAsSeTeSIn, GeAsSeTeSGa, GeAsSeTeSAl, GeAsSeTeSTl, GeAsSeTeSZn, GeAsSeTeSSn, GeAsSeTePIn, GeAsSeTePGa, GeAsSeTePAl, GeAsSeTePTl, GeAsSeTePZn, GeAsSeTePSn, GeSiAsSeInGa, GeSiAsSeInAl, GeSiAsSeInTl, GeSiAsSeInZn, GeSiAsSeInSn, GeSiAsSeGaAl, GeSiAsSeGaTl, GeSiAsSeGaZn, GeSiAsSeGaSn, GeSiAsSeAlSn, GeAsSeTeInGa, GeAsSeTeInAl, GeAsSeTeInTl, GeAsSeTeInZn, GeAsSeTeInSn, GeAsSeTeGaAl, GeAsSeTeGaTl, GeAsSeTeGaZn, GeAsSeTeGaSn, GeAsSeTeAlSn, GeAsSeSInGa, GeAsSeSInAl, GeAsSeSInTl, GeAsSeSInZn, GeAsSeSInSn, GeAsSeSGaAl, GeAsSeSGaTl, GeAsSeSGaZn, GeAsSeSGaSn, and/or GeAsSeSAlSn. In some implementations, the selection material layer SML may include at least one material selected from a group consisting of the two-component and six-component materials described above and at least one additional element selected from a group consisting of B, C, N, and O.

In a case in which the selector SLT includes a material having OTS characteristics, when a voltage greater than or equal to a threshold voltage (Vth) is applied to both sides of the selector SLT, the resistance or threshold voltage in the selector SLT may be significantly lowered due to the threshold switching phenomenon, thereby leading to a turn-on state in which current flows. When a current less than or equal to a certain threshold (Ihold) flows through the selector SLT in the turn-on state, the resistance or threshold voltage in the selector SLT increases significantly, thereby leading to a turn-off state in which almost no current flows through the selector SLT. Here, the turn-on state and the turn-off state may correspond to different logic states (set (SET) state or reset (RESET) state).

The memory cell structure CST may include a word line contact WLC, which electrically connects the word line WL to the upper peripheral circuit structure UPST, and a bit line contact BLC, which electrically connects the bit line BL to the upper peripheral circuit structure UPST. FIG. 3 shows the word line contact WLC connected to one word line WL among the plurality of word lines WL and the bit line contact BLC connected to one bit line BL among the plurality of bit lines BL, for the convenience of illustration, but implementations are not limited thereto. For example, the memory cell structure CST may include a plurality of word line contacts WLC connected to the plurality of word lines WL and a plurality of bit line contacts BLC connected to the plurality of bit lines BL. In some implementations, the word line contact WLC may pass through the interlayer insulating layer ILD and electrically connect the word line WL to the corresponding upper wiring line PMLU. In some implementations, the bit line contact BLC may pass through the interlayer insulating layer ILD and electrically connect the bit line BL to the corresponding upper wiring line PMLU.

The upper wiring structure FPST may include a plurality of upper contact plugs CTA and an upper cover insulating layer CDU surrounding the plurality of upper contact plugs CTA. The plurality of upper contact plugs CTA may pass through the upper cover insulating layer CDU and the interlayer insulating layer ILD and be electrically connected to the upper peripheral circuit structure UPST. The plurality of upper contact plugs CTA may be electrically connected to the plurality of upper wiring lines PMLU. The plurality of upper contact plugs CTA may contact the plurality of upper wiring lines PMLU. As an example, the plurality of upper contact plugs CTA may be electrically connected to the upper local word line selection transistor LX-F and the upper local bit line selection transistor LY-F and supply power to the upper local word line selection transistor LX-F and the upper local bit line selection transistor LY-F.

The lower wiring structure BPST may include a plurality of lower contact plugs CTB and a lower cover insulating layer CDD surrounding the plurality of lower contact plugs CTB. The plurality of lower contact plugs CTB may pass through the lower cover insulating layer CDD and be electrically connected to the lower peripheral circuit structure DPST. The plurality of lower contact plugs CTB may be electrically connected to the plurality of lower wiring lines PMLD. The plurality of lower contact plugs CTB may contact the plurality of lower wiring lines PMLD. As an example, the plurality of lower contact plugs CTB may be electrically connected to the lower local word line selection transistor LX-R and the lower local bit line selection transistor LY-R and supply power to the lower local word line selection transistor LX-R and the lower local bit line selection transistor LY-R.

The upper contact plugs CTA and the lower contact plugs CTB may each include a metal layer and a conductive metal nitride layer surrounding the metal layer. For example, the metal layer may include W or Al, and the conductive metal nitride layer may include TiN or TaN. The lower cover insulating layer CDD and the upper cover insulating layer CDU may each contain insulating materials that may include silicon oxide, silicon nitride, low-k materials, ULK materials, or a combination thereof. The upper contact plug CTA may have a tapered shape in which the horizontal width of the upper contact plug CTA decreases from the upper wiring structure FPST toward the upper peripheral circuit structure UPST. The lower contact plug CTB may have a tapered shape in which the horizontal width of the lower contact plug CTB decreases from the lower wiring structure BPST toward the lower peripheral circuit structure DPST.

The plurality of vertical through-electrodes TSV may electrically connect the upper peripheral circuit structure UPST to the lower peripheral circuit structure DPST. For example, the plurality of vertical through-electrodes TSV may electrically connect the lower local word line selection transistor LX-R to the upper local word line selection transistor LX-F and also electrically connect the lower local bit line selection transistor LY-R to the upper local bit line selection transistor LY-F. In some implementations, the plurality of vertical through-electrodes TSV may electrically connect the plurality of lower wiring lines PMLD to the plurality of upper wiring lines PMLU. For example, the plurality of vertical through-electrodes TSV may pass through the lower wiring insulating layer IMDD, the lower semiconductor substrate PSUBD, the bonding structure BDDI, the upper semiconductor substrate PSUBU, and the upper wiring insulating layer IMDU, and may electrically connect the plurality of lower wiring lines PMLD to the plurality of upper wiring lines PMLU.

Each of the plurality of vertical through-electrodes TSV may include a conductive plug and a conductive barrier layer surrounding the surface of the conductive plug. For example, the conductive plug may include Cu or W. In some implementations, the conductive plug may include, but is not limited to, Cu, CuSn, CuMg, CuNi, CuZn, CuPd, CuAu, CuRe, CuW, W, or a W alloy. In some implementations, the conductive barrier layer may include at least one material selected from a group consisting of Ti, TiN, Ta, TaN, Ru, Co, Mn, WN, Ni, and NiB. In some implementations, a via insulating layer may be located between each of the plurality of vertical through-electrodes TSV and the lower semiconductor substrate PSUBD and between each of the plurality of vertical through-electrodes TSV and the upper semiconductor substrate PSUBU. For example, the via insulating layer may include an oxide layer, a nitride layer, a carbide layer, polymer, or a combination thereof. Each of the plurality of vertical through-electrodes TSV may have a tapered shape in which the horizontal width of the vertical through-electrode TSV decreases from the lower peripheral circuit structure DPST toward the upper peripheral circuit structure UPST. For instance, the horizontal width of the vertical through-electrode TSV may decrease in a direction from the lower wiring lines PMLD towards the upper wiring lines PMLU.

In the semiconductor memory device 1 , the upper peripheral circuit structure UPST, which includes the upper local word line selection transistor LX-F and the upper local bit line selection transistor LY-F, may be disposed above the lower peripheral circuit structure DPST, which includes the lower local word line selection transistor LX-R and the lower local bit line selection transistor LY-R, and thus, the upper peripheral circuit structure UPST may overlap the lower peripheral circuit structure DPST in the vertical direction. Therefore, the area of the semiconductor memory device 1 may decrease or the degree of integration thereof may increase based on the same area. In addition, the lower local word line selection transistor LX-R and the upper local word line selection transistor LX-F, and the lower local bit line selection transistor LY-R and the upper local bit line selection transistor LY-F are electrically connected to each other via the plurality of vertical through-electrodes TSV. Therefore, the electrical paths therebetween may be shortened, which may improve the operating performance of the semiconductor memory device 1.

Also, in the semiconductor memory device 1, the upper peripheral circuit structure UPST, which includes the upper local word line selection transistor LX-F and the upper local bit line selection transistor LY-F, is supplied with power via the plurality of upper contact plugs CTA in the upper wiring structure FPST. Also, the lower peripheral circuit structure DPST, which includes the lower local word line selection transistor LX-R and the lower local bit line selection transistor LY-R, is supplied with power via the plurality of lower contact plugs CTB in the lower wiring structure BPST. Accordingly, the arrangement of wiring lines in the semiconductor memory device 1 may be simplified, thereby increasing the degree of integration of the semiconductor memory device 1 and improving the operating performance thereof.

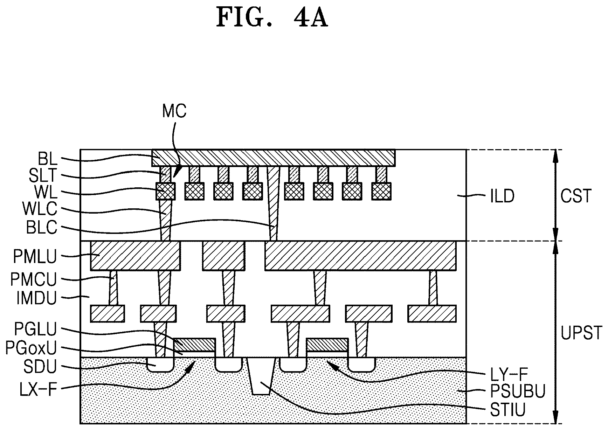

FIGS. 4A to 4F are cross-sectional views illustrating a method of manufacturing a semiconductor memory device, according to implementations.

Referring to FIG. 4A, the upper peripheral circuit structure UPST is formed, and then the memory cell structure CST is formed on the upper peripheral circuit structure UPST. For example, the upper peripheral circuit structure UPST may be formed by forming, on the upper semiconductor substrate PSUBU, the upper device isolation layer STIU, the upper local word line selection transistor LX-F, and the upper local bit line selection transistor LY-F, then forming the plurality of upper wiring lines PMLU and the plurality of upper wiring contacts PMCU, which are electrically connected to the upper local word line selection transistor LX-F and the upper local bit line selection transistor LY-F, and then forming the upper wiring insulating layer IMDU surrounding the plurality of upper wiring lines PMLU and the plurality of upper wiring contacts PMCU.

For example, the memory cell structure CST may be formed by forming, on the upper peripheral circuit structure UPST, the plurality of word lines WL extending in the first horizontal direction, the plurality of bit lines BL extending in the second horizontal direction, the plurality of selectors SLT arranged between the plurality of word lines WL and the plurality of bit lines BL, the interlayer insulating layer ILD surrounding the plurality of word lines WL, the plurality of bit lines BL, and the plurality of selectors SLT, the plurality of word line contacts WLC passing through the interlayer insulating layer ILD and electrically connecting the plurality of word lines WL to the plurality of upper wiring line PMLU, and the plurality of bit line contacts BLC passing through the interlayer insulating layer ILD and electrically connecting the plurality of bit lines BL to the plurality of upper wiring lines PMLU.

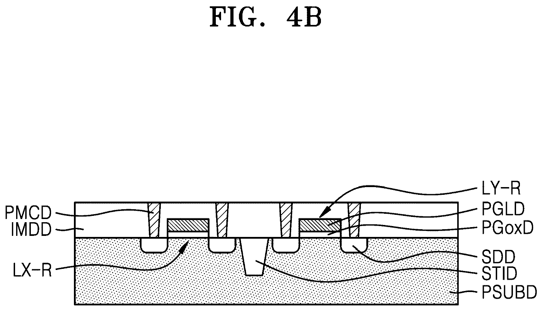

Referring to FIG. 4B, the lower device isolation layer STID, the lower local word line selection transistor LX-R, and the lower local bit line selection transistor LY-R are formed in the lower semiconductor substrate PSUBD. Subsequently, the plurality of lower wiring contacts PMCD are electrically connected to the lower local word line selection transistor LX-R and the lower local bit line selection transistor LY-R, and the lower wiring insulating layer IMDD surrounds the plurality of lower wiring contacts PMCD. The resulting structure in FIG. 4B may be referred to as a preliminary lower wiring structure.

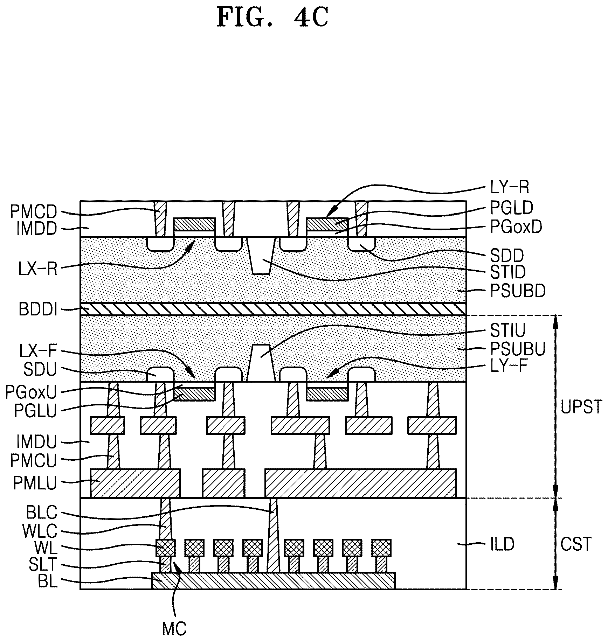

Referring to FIG. 4C, the resulting structure of FIG. 4A is turned over such that the memory cell structure CST is located at the bottom and the upper peripheral circuit structure UPST is located at the top. Subsequently, the preliminary lower wiring structure, which is the resulting structure of FIG. 4B, is attached to the upper peripheral circuit structure UPST. The preliminary lower wiring structure may be attached above the upper peripheral circuit structure UPST such that the bonding structure BDDI is located between the upper semiconductor substrate PSUBU and the lower semiconductor substrate PSUBD. In some implementations, the preliminary lower wiring structure may be attached above the upper peripheral circuit structure UPST such that the upper local word line selection transistor LX-F, the upper local bit line selection transistor LY-F, the lower local word line selection transistor LX-R, and the lower local bit line selection transistor LY-R are arranged on the opposite sides of the upper semiconductor substrate PSUBU and the lower semiconductor substrate PSUBD.

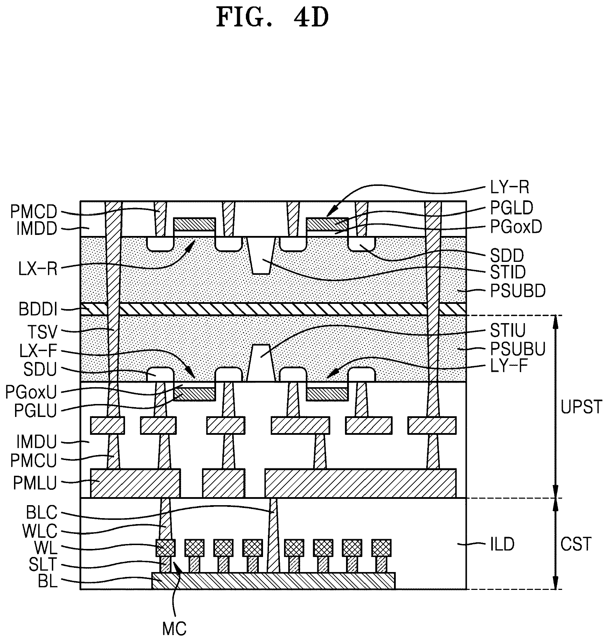

Referring to FIG. 4D, the plurality of vertical through-electrodes TSV passing through the lower wiring insulating layer IMDD, the lower semiconductor substrate PSUBD, the bonding structure BDDI, the upper semiconductor substrate PSUBU, and the upper wiring insulating layer IMDU, and are connected to the plurality of upper wiring lines PMLU.

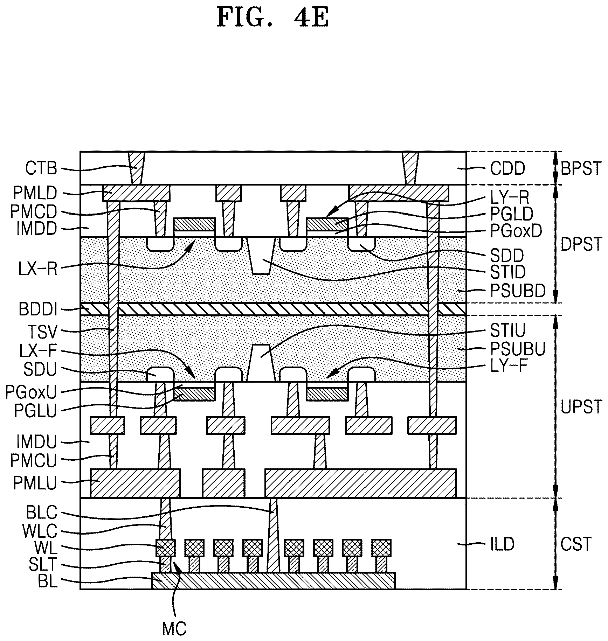

Referring to FIG. 4E, the plurality of lower wiring lines PMLD are connected to the plurality of lower wiring contacts PMCD, thereby forming the lower peripheral circuit structure DPST. In some implementations, an insulating material layer may surround the plurality of lower wiring lines PMLD, and thus, the lower wiring insulating layer IMDD including the insulating material layer may surround the plurality of lower wiring contacts PMCD and the plurality of lower wiring lines PMLD.

The lower wiring structure BPST, which includes the plurality of lower contact plugs CTB and the lower cover insulating layer CDD surrounding the plurality of lower contact plugs CTB, is formed on the lower peripheral circuit structure DPST. The plurality of lower contact plugs CTB may pass through the lower cover insulating layer CDD and be connected to the plurality of lower wiring lines PMLD.

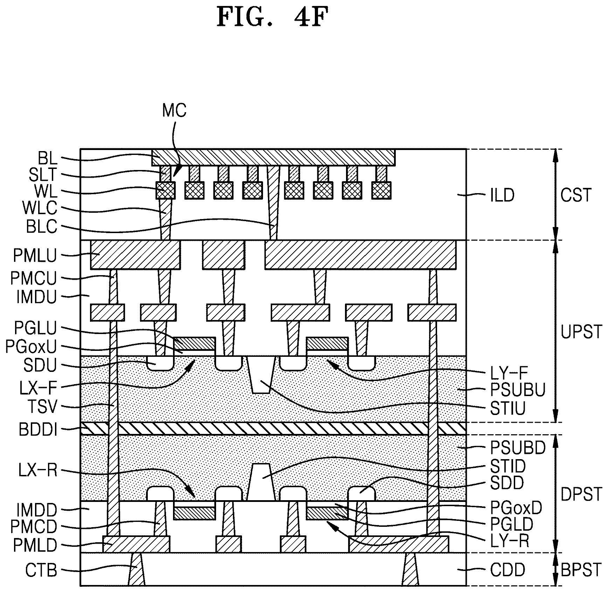

Referring to FIG. 4F, the resulting structure of FIG. 4E is turned over such that the lower wiring structure BPST is located at the bottom and the memory cell structure CST is located at the top.

Subsequently, as shown in FIG. 3, the semiconductor memory device 1 is formed by forming, on the memory cell structure CST, the upper wiring structure FPST that includes the plurality of upper contact plugs CTA and the upper cover insulating layer CDU surrounding the plurality of upper contact plugs CTA. The plurality of upper contact plugs CTA may pass through the upper cover insulating layer CDU and the interlayer insulating layer ILD and then be connected to the plurality of upper wiring lines PMLU.

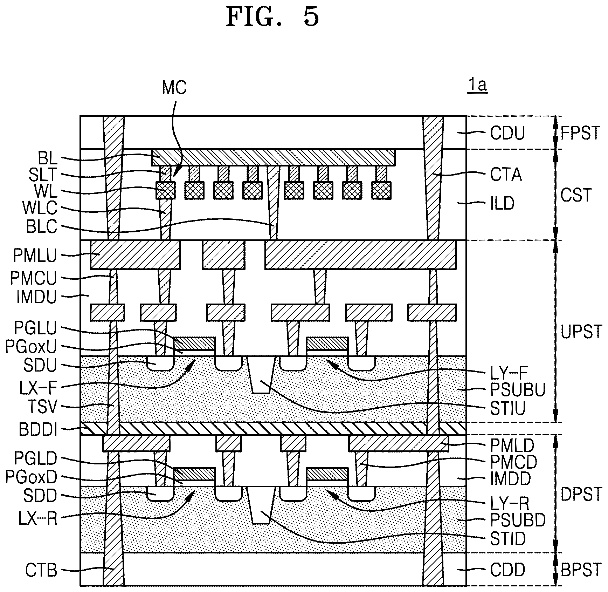

FIG. 5 is a cross-sectional view of a semiconductor memory device 1a according to implementations.

Referring to FIG. 5, the semiconductor memory device 1a may include the lower peripheral circuit structure DPST, the upper peripheral circuit structure UPST, and the memory cell structure CST, which are sequentially stacked in the vertical direction. The bonding structure BDDI may be located between the lower peripheral circuit structure DPST and the upper peripheral circuit structure UPST. For example, the lower surface of the bonding structure BDDI may cover the upper surfaces of lower wiring lines PMLD located uppermost among the plurality of lower wiring lines PMLD and the upper surface of the lower wiring insulating layer IMDD, and the upper surface of the bonding structure BDDI may cover the lower surface of the upper semiconductor substrate PSUBU. The lower wiring structure BPST may be disposed below the lower peripheral circuit structure DPST, and the upper wiring structure FPST may be disposed on the memory cell structure CST. The lower wiring structure BPST, the lower peripheral circuit structure DPST, the bonding structure BDDI, the upper peripheral circuit structure UPST, the memory cell structure CST, and the upper wiring structure FPST may overlap each other in the vertical direction. The lower peripheral circuit structure DPST may be electrically connected to the upper peripheral circuit structure UPST via the plurality of vertical through-electrodes TSV.

The upper local word line selection transistor LX-F, the upper local bit line selection transistor LY-F, the lower local word line selection transistor LX-R, and the lower local bit line selection transistor LY-R may be arranged on the sides, facing the memory cell structure CST, of the upper semiconductor substrate PSUBU and the lower semiconductor substrate PSUBD. For example, the upper peripheral circuit structure UPST may have a face-up structure in which the upper local word line selection transistor LX-F and the upper local bit line selection transistor LY-F are located on the upper side of the upper semiconductor substrate PSUBU, which faces the memory cell structure CST. The lower peripheral circuit structure DPST may have a face-up structure in which the lower local word line selection transistor LX-R and the lower local bit line selection transistor LY-R are located on the upper side of the lower semiconductor substrate PSUBD, which faces the memory cell structure CST.

The plurality of upper contact plugs CTA may pass through the upper cover insulating layer CDU and the interlayer insulating layer ILD and be electrically connected to the plurality of upper wiring lines PMLU. The plurality of lower contact plugs CTB may pass through the lower cover insulating layer CDD, the lower semiconductor substrate PSUBD, and the lower wiring insulating layer IMDD and be electrically connected to the plurality of lower wiring lines PMLD. The plurality of vertical through-electrodes TSV may pass through the bonding structure BDDI, the upper semiconductor substrate PSUBU, and the upper wiring insulating layer IMDU and electrically connect the plurality of lower wiring lines PMLD to the plurality of upper wiring lines PMLU.

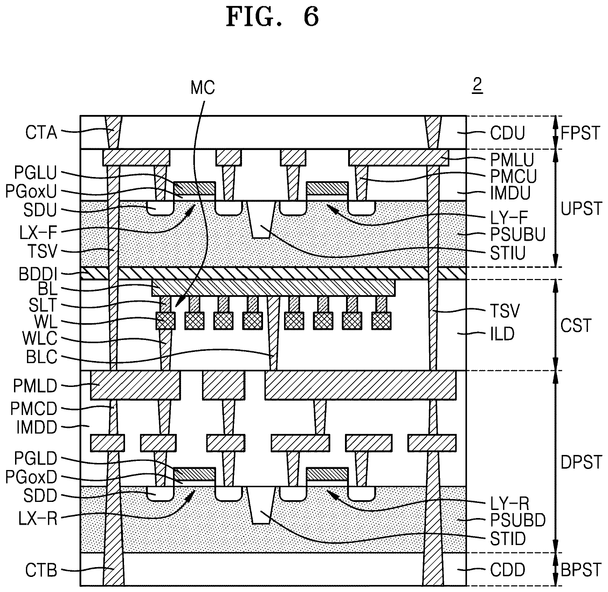

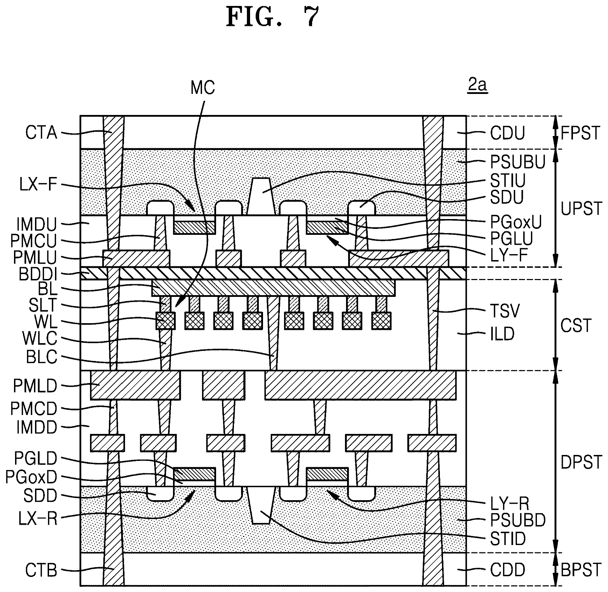

FIGS. 6 and 7 are cross-sectional views of semiconductor memory devices 2 and 2a, respectively, according to implementations.

Referring to FIG. 6, the semiconductor memory device 2 may include the lower peripheral circuit structure DPST, the memory cell structure CST, and the upper peripheral circuit structure UPST, which are sequentially stacked in the vertical direction. The bonding structure BDDI may be located between the memory cell structure CST and the upper peripheral circuit structure UPST. For example, the lower surface of the bonding structure BDDI may cover the upper surfaces of the plurality of bit lines BL and the upper surface of the interlayer insulating layer ILD, and the upper surface of the bonding structure BDDI may cover the lower surface of the upper semiconductor substrate PSUBU. The lower wiring structure BPST may be disposed below the lower peripheral circuit structure DPST, and the upper wiring structure FPST may be disposed on the upper peripheral circuit structure UPST. The lower wiring structure BPST, the lower peripheral circuit structure DPST, the memory cell structure CST, the bonding structure BDDI, the upper peripheral circuit structure UPST, and the upper wiring structure FPST may overlap each other in the vertical direction. The lower peripheral circuit structure DPST may be electrically connected to the upper peripheral circuit structure UPST via the plurality of vertical through-electrodes TSV.

The upper local word line selection transistor LX-F, the upper local bit line selection transistor LY-F may be located on a side of the upper semiconductor substrate PSUBU facing away from the memory cell structure CST (e.g., facing the upper wiring structure FPST). The lower local word line selection transistor LX-R and the lower local bit line selection transistor LY-R may be arranged on the side of the lower semiconductor substrate PSUBD facing the memory cell structure CST. For example, the upper peripheral circuit structure UPST may have a face-up structure in which the upper local word line selection transistor LX-F and the upper local bit line selection transistor LY-F are located on the upper side of the upper semiconductor substrate PSUBU, which faces the upper wiring structure FPST. Also, the lower peripheral circuit structure DPST may have a face-up structure in which the lower local word line selection transistor LX-R and the lower local bit line selection transistor LY-R are located on the upper side of the lower semiconductor substrate PSUBD, which faces the memory cell structure CST.

The plurality of upper contact plugs CTA may pass through the upper cover insulating layer CDU and be electrically connected to the plurality of upper wiring lines PMLU. The plurality of lower contact plugs CTB may pass through the lower cover insulating layer CDD, the lower semiconductor substrate PSUBD, and the lower wiring insulating layer IMDD and be electrically connected to the plurality of lower wiring lines PMLD. The plurality of vertical through-electrodes TSV may pass through the upper wiring insulating layer IMDU, the upper semiconductor substrate PSUBU, the bonding structure BDDI, and the interlayer insulating layer ILD and electrically connect the plurality of lower wiring lines PMLD to the plurality of upper wiring lines PMLU.

Referring to FIG. 7, the semiconductor memory device 2a may include the lower peripheral circuit structure DPST, the memory cell structure CST, and the upper peripheral circuit structure UPST, which are sequentially stacked in the vertical direction. The bonding structure BDDI may be located between the memory cell structure CST and the upper peripheral circuit structure UPST. For example, the lower surface of the bonding structure BDDI may cover the upper surfaces of the plurality of bit lines BL and the upper surface of the interlayer insulating layer ILD, and the upper surface of the bonding structure BDDI may cover the lower surfaces of upper wiring lines PMLU located lowermost among the plurality of upper wiring lines PMLU and the lower surface of the upper wiring insulating layer IMDU. The lower wiring structure BPST may be disposed below the lower peripheral circuit structure DPST, and the upper wiring structure FPST may be disposed on the upper peripheral circuit structure UPST. The lower wiring structure BPST, the lower peripheral circuit structure DPST, the memory cell structure CST, the bonding structure BDDI, the upper peripheral circuit structure UPST, and the upper wiring structure FPST may overlap each other in the vertical direction. The lower peripheral circuit structure DPST may be electrically connected to the upper peripheral circuit structure UPST via the plurality of vertical through-electrodes TSV.

The upper local word line selection transistor LX-F, the upper local bit line selection transistor LY-F, the lower local word line selection transistor LX-R, and the lower local bit line selection transistor LY-R may be arranged on the opposite sides of the upper semiconductor substrate PSUBU and the lower semiconductor substrate PSUBD. For example, the upper peripheral circuit structure UPST may have a face-down structure in which the upper local word line selection transistor LX-F and the upper local bit line selection transistor LY-F are located on the lower side of the upper semiconductor substrate PSUBU, which faces the memory cell structure CST. The lower peripheral circuit structure DPST may have a face-up structure in which the lower local word line selection transistor LX-R and the lower local bit line selection transistor LY-R are located on the upper side of the lower semiconductor substrate PSUBD, which faces the memory cell structure CST.

The plurality of upper contact plugs CTA may pass through the upper cover insulating layer CDU, the upper semiconductor substrate PSUBU, and the upper wiring insulating layer IMDU and be electrically connected to the plurality of upper wiring lines PMLU. The plurality of lower contact plugs CTB may pass through the lower cover insulating layer CDD, the lower semiconductor substrate PSUBD, and the lower wiring insulating layer IMDD and then be electrically connected to the plurality of lower wiring lines PMLD. The plurality of vertical through-electrodes TSV may pass through the bonding structure BDDI and the interlayer insulating layer ILD and electrically connect the plurality of lower wiring lines PMLD to the plurality of upper wiring lines PMLU.

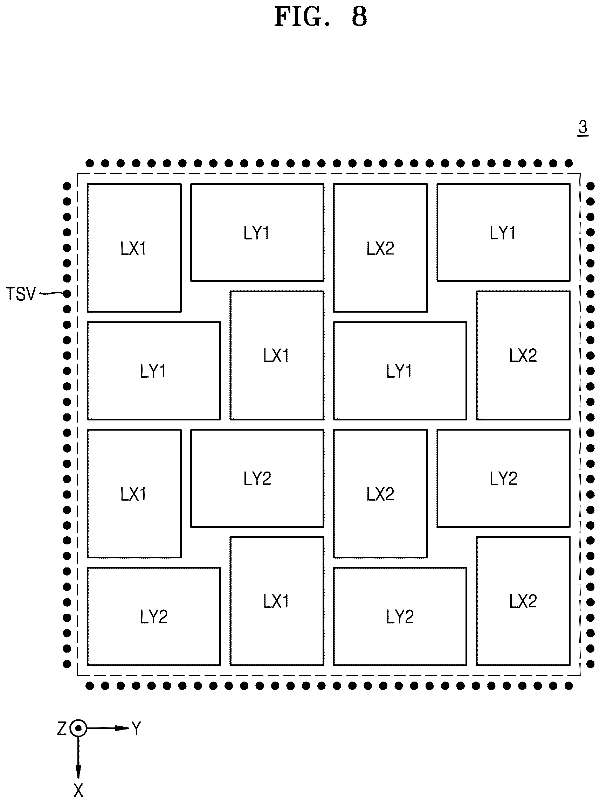

FIG. 8 is a conceptual diagram illustrating a semiconductor memory device 3 according to implementations.

Referring to FIG. 8, the semiconductor memory device 3 may include regions in which a plurality of first local word line selection transistors LX1 are arranged, regions in which a plurality of second local word line selection transistors LX2 are arranged, regions in which a plurality of first local bit line selection transistors LY1 are arranged, and regions in which the plurality of second local bit line selection transistors LY2 are arranged. The regions in which the plurality of first local word line selection transistors LX1 are arranged, the regions in which the plurality of second local word line selection transistors LX2 are arranged, the regions in which the plurality of first local bit line selection transistors LY1 are arranged, and the regions in which the plurality of second local bit line selection transistors LY2 are arranged, may each be referred to as a tile. One of a region in which a first local word line selection transistor LX1 is located and a region in which a second local word line selection transistor LX2 is located and one of a region in which a first local bit line selection transistor LY1 is located and a region in which a second local bit line selection transistor LY2 is located may be alternately arranged in each of the first horizontal direction (the X direction) and the second horizontal direction (the Y direction). The regions in which the plurality of first local word line selection transistors LX1 are arranged and the regions in which the plurality of second local word line selection transistors LX2 may be alternately arranged in the first horizontal direction (the X direction), and the regions in which the plurality of first local bit line selection transistors LY1 are arranged and the regions in which the plurality of second local bit line selection transistors LY2 are arranged may be alternately arranged in the second horizontal direction (the Y direction). In some implementations, in a plan view, each of the regions in which the plurality of first local word line selection transistors LX1 are arranged and the regions in which the plurality of second local word line selection transistors LX2 are arranged may have a rectangular shape having a long side in the first horizontal direction (the X direction) and a short side in the second horizontal direction (the Y direction). In some implementations, in a plan view, each of the regions in which the plurality of first local bit line selection transistors LY1 are arranged and the regions in which the plurality of second local bit line selection transistors LY2 are arranged may have a rectangular shape having a long side in the second horizontal direction (the Y direction) and a short side in the first horizontal direction (the X direction).

The plurality of vertical through-electrodes TSV may surround the regions in which the plurality of first local word line selection transistors LX1 are arranged, the regions in which the plurality of second local word line selection transistors LX2 are arranged, the regions in which the plurality of first local bit line selection transistors LY1 are arranged, and the regions in which the plurality of second local bit line selection transistors LY2 are arranged.

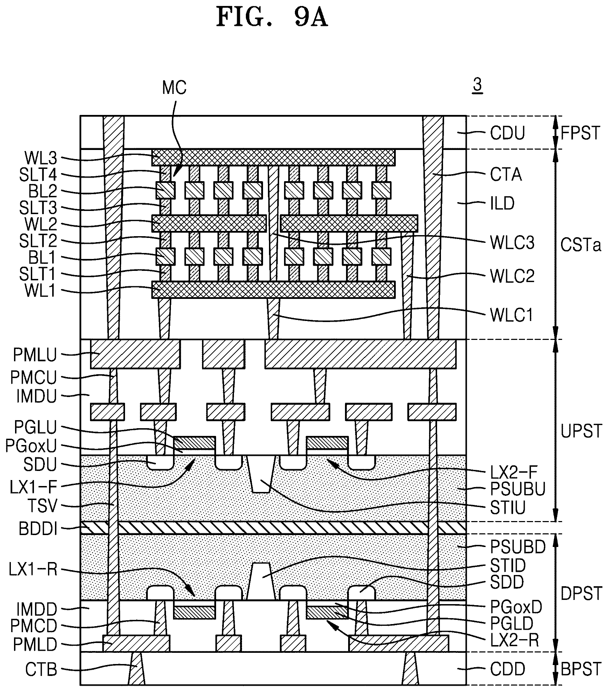

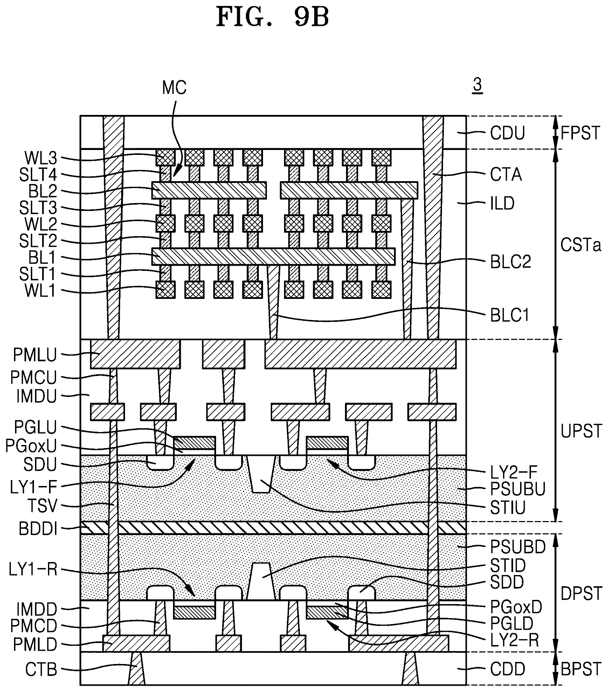

In each of the regions in which the plurality of first local word line selection transistors LX1 are arranged, a first lower local word line selection transistor LX1-R and a first upper local word line selection transistor LX1-F above the first lower local word line selection transistor LX1-R may be arranged as shown in FIG. 9A. In each of the regions in which the plurality of second local word line selection transistors LX2 are arranged, a second lower local word line selection transistor LX2-R and a second upper local word line selection transistor LX2-F above the second lower local word line selection transistor LX2-R may be arranged as shown in FIG. 9A. In each of the regions in which the plurality of first local bit line selection transistors LY1 are arranged, a first lower local bit line selection transistor LY1-R and a first upper local bit line selection transistor LY1-F above the first lower local bit line selection transistor LY1-R may be arranged as shown in FIG. 9B. In each of the regions in which the plurality of second local bit line selection transistors LY2 are arranged, a second lower local bit line selection transistor LY2-R and a second upper local bit line selection transistor LY2-F above the second lower local bit line selection transistor LY2-R may be arranged as shown in FIG. 9B.

FIGS. 9A and 9B are cross-sectional views of a semiconductor memory device 3 according to implementations.

Referring to FIGS. 9A and 9B together, the semiconductor memory device 3 may include the lower peripheral circuit structure DPST, the upper peripheral circuit structure UPST, and a memory cell structure CSTa, which are sequentially stacked in the vertical direction. The bonding structure BDDI may be located between the lower peripheral circuit structure DPST and the upper peripheral circuit structure UPST. The lower wiring structure BPST may be disposed below the lower peripheral circuit structure DPST, and the upper wiring structure FPST may be disposed on the memory cell structure CSTa. The lower wiring structure BPST, the lower peripheral circuit structure DPST, the bonding structure BDDI, the upper peripheral circuit structure UPST, the memory cell structure CSTa, and the upper wiring structure FPST may overlap each other in the vertical direction. The lower peripheral circuit structure DPST may be electrically connected to the upper peripheral circuit structure UPST via the plurality of vertical through-electrodes TSV. The upper peripheral circuit structure UPST may have a face-up structure and the lower peripheral circuit structure DPST may have a face-down structure.

The memory cell structure includes a plurality of first word lines WL1, a plurality of second word lines WL2, and a plurality of third word lines WL3, which extend in the first horizontal direction, and a plurality of first bit lines BL1 and a plurality of second bit lines BL2, which extend in the second horizontal direction. The plurality of first word lines WL1, the plurality of second word lines WL2, and the plurality of third word lines WL3 may be at different vertical levels, and the plurality of first bit lines BL1 and the plurality of second bit lines BL2 may be at different vertical levels. In some implementations, for example, the plurality of first bit lines BL1 may be located between the plurality of first word lines WL1 and the plurality of second word lines WL2 in the vertical direction, and the plurality of second bit lines BL2 may be located between the plurality of second word lines WL2 and the plurality of third word lines WL3 in the vertical direction. For example, the plurality of first word lines WL1, the plurality of first bit lines BL1, the plurality of second word lines WL2, the plurality of second bit lines BL2, and the plurality of third word lines WL3 may be sequentially arranged in the vertical direction.

The memory cell structure CSTa includes a plurality of first selectors SLT1 between the plurality of first word lines WL1 and the plurality of first bit lines BL1, a plurality of second selectors SLT2 between the plurality of first bit lines BL1 and the plurality of second word lines WL2, a plurality of third selectors SLT3 between the plurality of second word lines WL2 and the plurality of second bit lines BL2, and a plurality of fourth selectors SLT4 between the plurality of second bit lines BL2 and the plurality of third word lines WL3, and an interlayer insulating layer ILD that surrounds the plurality of first word lines WL1, the plurality of second word lines WL2, the plurality of third word lines WL3, the plurality of first bit lines BL1, the plurality of second bit lines BL2, the plurality of first selectors SLT1, the plurality of second selectors SLT2, the plurality of third selectors SLT3, and the plurality of fourth selectors SLT4. The plurality of first selectors SLT1, the plurality of second selectors SLT2, the plurality of third selectors SLT3, and the plurality of fourth selectors SLT4 may constitute a plurality of memory cells MC.

Each of the plurality of first word lines WL1, the plurality of second word lines WL2, and the plurality of third word lines WL3 may be substantially the same as the plurality of word lines WL shown in FIG. 3, each of the plurality of first bit lines BL1 and the plurality of second bit lines BL2 may be substantially the same as the plurality of bit lines BL shown in FIG. 3, and each of the plurality of first selectors SLT1, the plurality of second selectors SLT2, the plurality of third selectors SLT3, and the plurality of fourth selectors SLT4 may be substantially the same as the plurality of selectors SLT shown in FIG. 3. Therefore, repeated descriptions as those given above are omitted.

The memory cell structure CSTa may include a first word line contact WLC1 for electrically connecting the first word line WL1 to the upper peripheral circuit structure UPST, a second word line contact WLC2 for electrically connecting the second word line WL2 to the upper peripheral circuit structure UPST, and a third word line contact WLC3 for electrically connecting the third word line WL3 to the first word line WL1. The memory cell structure CSTa may include a first bit line contact BLC1 for electrically connecting the first bit line BL1 to the upper peripheral circuit structure UPST and a second bit line contact BLC2 for electrically connecting the second bit line BL2 to the upper peripheral circuit structure UPST. In some implementations, the first word line contact WLC1 and the second word line contact WLC2 may pass through the interlayer insulating layer ILD and electrically connect the first word line WL1 and the second word line WL2, respectively, to the upper wiring line PMLU. The third word line contact WLC3 may pass through the interlayer insulating layer ILD and electrically connect the third word line WL3 to the first word line WL1. In some implementations, the first bit line contact BLC1 and the second bit line contact BLC2 may pass through the interlayer insulating layer ILD and electrically connect the first bit line BL1 and the second bit line BL2, respectively, to the upper wiring line PMLU.

The lower peripheral circuit structure DPST may include a plurality of lower transistors and the upper peripheral circuit structure UPST may include a plurality of upper transistors. The plurality of lower transistors may include the first lower local word line selection transistor LX1-R, the second lower local word line selection transistor LX2-R, the first lower local bit line selection transistor LY1-R, and the second lower local bit line selection transistor LY2-R. The plurality of upper transistors may include the first upper local word line selection transistor LX1-F, the second upper local word line selection transistor LX2-F, the first upper local bit line selection transistor LY1-F, and the second upper local bit line selection transistor LY2-F. Each of the first word line WL1, the second word line WL2, and the third word line WL3 may be electrically connected to the first lower local word line selection transistor LX1-R and the first upper local word line selection transistor LX1-F or electrically connected to the second lower local word line selection transistor LX2-R and the second upper local word line selection transistor LX2-F. Each of the first bit line BL1 and the second bit line BL2 may be electrically connected to the first lower local bit line selection transistor LY1-R and the first upper local bit line selection transistor LY1-F or electrically connected to the second lower local bit line selection transistor LY2-R and the second upper local bit line selection transistor LY2-F.

The first lower local word line selection transistor LX1-R and the first upper local word line selection transistor LX1-F, which are connected to any one of the first word line WL1, the second word line WL2, and the third word line WL3, may at least partially overlap each other in the vertical direction. Also, the second lower local word line selection transistor LX2-R and the second upper local word line selection transistor LX2-F, which are connected to any one of the first word line WL1, the second word line WL2, and the third word line WL3, may at least partially overlap each other in the vertical direction. The first lower local bit line selection transistor LY1-R and the first upper local bit line selection transistor LY1-F, which are connected to either the first bit line BL1 or the second bit line BL2, may at least partially overlap each other in the vertical direction. The second lower local bit line selection transistor LY2-R and the second upper local bit line selection transistor LY2-F, which are connected to either the first bit line BL1 or the second bit line BL2, may at least partially overlap each other in the vertical direction.

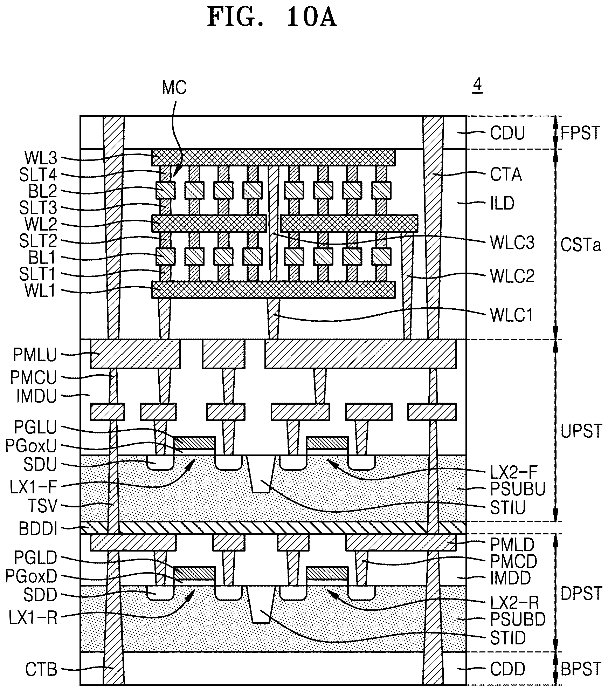

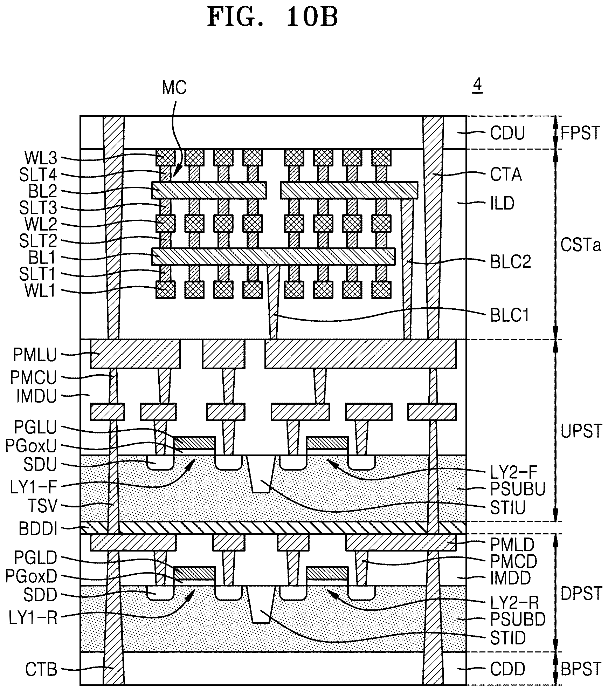

FIGS. 10A and 10B are cross-sectional views of a semiconductor memory device 4 according to implementations.

Referring to FIGS. 10A and 10B together, the semiconductor memory device 4 may include the lower peripheral circuit structure DPST, the upper peripheral circuit structure UPST, and the memory cell structure CSTa, which are sequentially stacked in the vertical direction. The bonding structure BDDI may be located between the lower peripheral circuit structure DPST and the upper peripheral circuit structure UPST. The lower wiring structure BPST may be disposed below the lower peripheral circuit structure DPST, and the upper wiring structure FPST may be disposed on the memory cell structure CSTa. The lower wiring structure BPST, the lower peripheral circuit structure DPST, the bonding structure BDDI, the upper peripheral circuit structure UPST, the memory cell structure CSTa, and the upper wiring structure FPST may overlap each other in the vertical direction. The lower peripheral circuit structure DPST may be electrically connected to the upper peripheral circuit structure UPST via the plurality of vertical through-electrodes TSV. The upper peripheral circuit structure UPST may have a face-up structure and the lower peripheral circuit structure DPST may have a face-up structure.

In some implementations, the upper peripheral circuit structure UPST in the semiconductor memory device 4 may be modified with reference to FIGS. 6 and 7 and thus disposed above the memory cell structure CSTa. For example, the upper peripheral circuit structure UPST disposed above the memory cell structure CSTa may have a face-up structure, which is similar to the upper peripheral circuit structure UPST shown in FIG. 6. For example, the upper peripheral circuit structure UPST disposed above the memory cell structure CSTa may have a face-down structure, which is similar to the upper peripheral circuit structure UPST shown in FIG. 7.

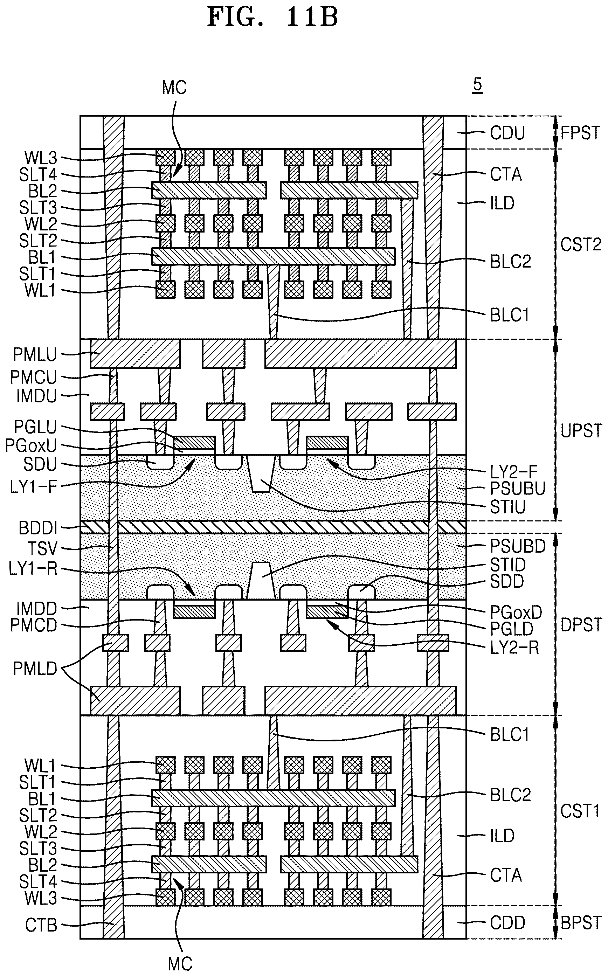

FIGS. 11A and 11B are cross-sectional views of a semiconductor memory device 5 according to implementations.

Referring to FIGS. 11A and 11B together, the semiconductor memory device 5 may include the first memory cell structure CST1, the lower peripheral circuit structure DPST, the upper peripheral circuit structure UPST, and the second memory cell structure CST2, which are sequentially stacked in the vertical direction. The bonding structure BDDI may be located between the lower peripheral circuit structure DPST and the upper peripheral circuit structure UPST. The lower wiring structure BPST may be disposed below the first memory cell structure CST1, and the upper wiring structure FPST may be disposed on the second memory cell structure CST2. The lower wiring structure BPST, the first memory cell structure CST1, the lower peripheral circuit structure DPST, the bonding structure BDDI, the upper peripheral circuit structure UPST, the second memory cell structure CST2, and the upper wiring structure FPST may overlap each other in the vertical direction. The lower peripheral circuit structure DPST may be electrically connected to the upper peripheral circuit structure UPST via the plurality of vertical through-electrodes TSV. The upper peripheral circuit structure UPST may have a face-up structure and the lower peripheral circuit structure DPST may have a face-down structure.

The first memory cell structure CST1 and the second memory cell structure CST2 have substantially the same structure, but the upper and lower sides thereof are opposite to each other. For example, the first memory cell structure CST1 may have a structure in which the memory cell structure CSTa shown in FIGS. 9A and 9B is turned over, and the second memory cell structure CST2 may have a structure which is substantially the same as the memory cell structure CSTa shown in FIGS. 9A and 9B. The semiconductor memory device 5 shown in FIGS. 11A and 11B has a structure in which the first memory cell structure CST1 is inserted between the lower wiring structure BPST and the lower peripheral circuit structure DPST in the semiconductor memory device 3 shown in FIGS. 9A and 9B and the second memory cell structure CST2 has a structure corresponding to the memory cell structure CSTa. Therefore, repeated descriptions as those given above are omitted. The first memory cell structure CST1 and the second memory cell structure CST2 may share the lower peripheral circuit structure DPST and the upper peripheral circuit structure UPST. The lower peripheral circuit structure DPST, the upper peripheral circuit structure UPST, the first memory cell structure CST1, and the second memory cell structure CST2 may have mirror-symmetrical structures with respect to the bonding structure BDDI in the vertical direction (the Z direction).

The plurality of upper contact plugs CTA may pass through the upper cover insulating layer CDU and the interlayer insulating layer ILD of the second memory cell structure CST2 and be electrically connected to the plurality of upper wiring lines PMLU. The plurality of lower contact plugs CTB may pass through the lower cover insulating layer CDD and the interlayer insulating layer ILD of the first memory cell structure CST1 and be electrically connected to the plurality of lower wiring lines PMLD. The plurality of vertical through-electrodes TSV may pass through the upper wiring insulating layer IMDU, the upper semiconductor substrate PSUBU, the bonding structure BDDI, and the lower semiconductor substrate PSUBD, and the lower wiring insulating layer IMDD and electrically connect the plurality of lower wiring lines PMLD to the plurality of upper wiring lines PMLU.

In some implementations, the upper peripheral circuit structure UPST in the semiconductor memory device 5 may be modified with reference to FIGS. 6 and 7 and thus disposed above the second memory cell structure CST2. For example, the upper peripheral circuit structure UPST disposed above the second memory cell structure CST2 may have a face-up structure, which is similar to the upper peripheral circuit structure UPST shown in FIG. 6. For example, the upper peripheral circuit structure UPST disposed above the second memory cell structure CST2 may have a face-down structure, which is similar to the upper peripheral circuit structure UPST shown in FIG. 7. In some implementations, the semiconductor memory device 5 may be modified such that the first memory cell structure CST1 is turned over or the second memory cell structure CST2 is turned over.

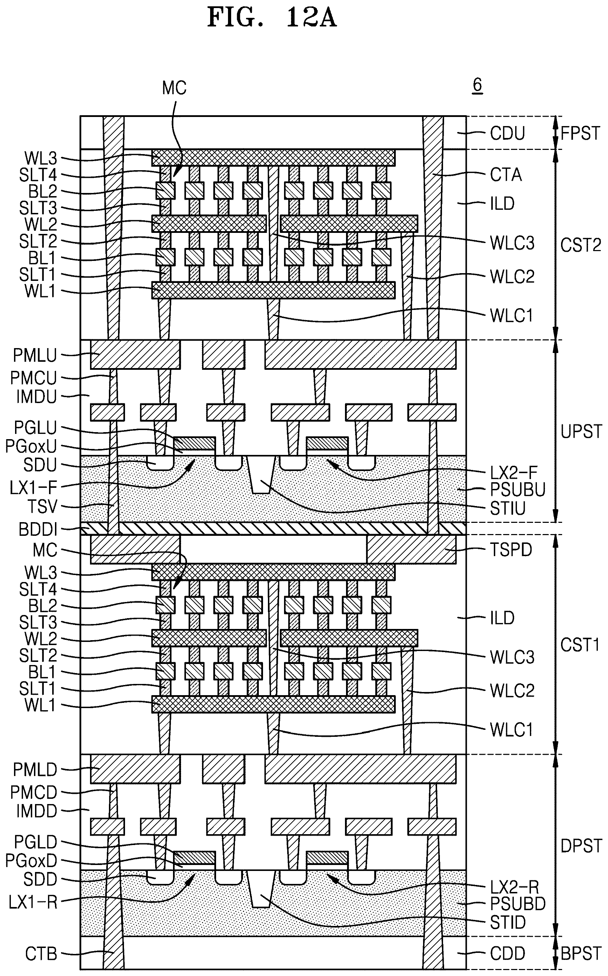

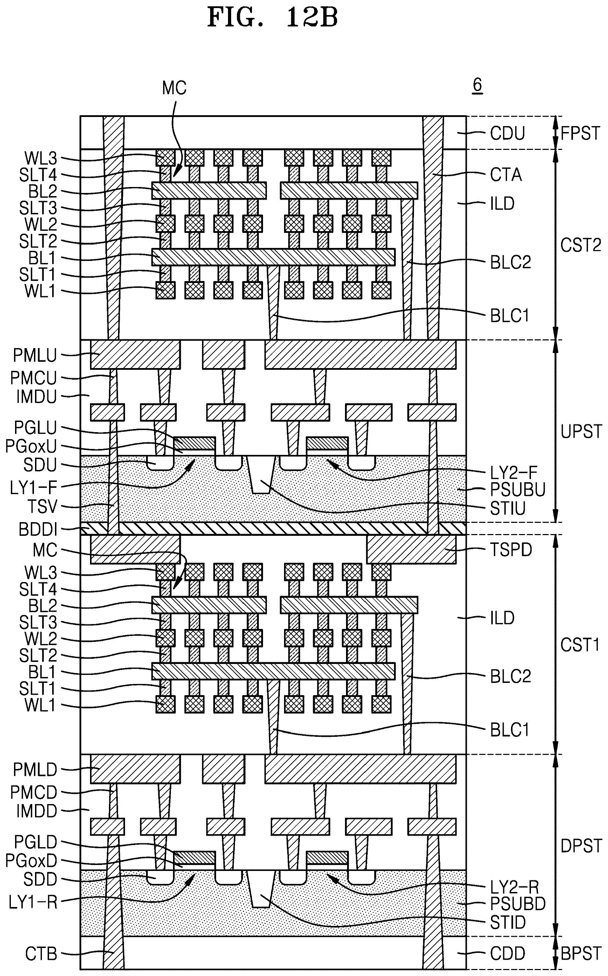

FIGS. 12A and 12B are cross-sectional views of a semiconductor memory device 6 according to implementations.

Referring to FIGS. 12A and 12B together, the semiconductor memory device 6 may include the lower peripheral circuit structure DPST, the first memory cell structure CST1, the upper peripheral circuit structure UPST, and the second memory cell structure CST2, which are sequentially stacked in the vertical direction. The bonding structure BDDI may be located between the first memory cell structure CST1 and the upper peripheral circuit structure UPST. The lower peripheral circuit structure DPST may be disposed below the first memory cell structure CST1, and the upper peripheral circuit structure UPST may be disposed below the second memory cell structure CST2. The lower wiring structure BPST, the lower peripheral circuit structure DPST, the first memory cell structure CST1, the bonding structure BDDI, the upper peripheral circuit structure UPST, the second memory cell structure CST2, and the upper wiring structure FPST may overlap each other in the vertical direction. The lower peripheral circuit structure DPST may be electrically connected to the upper peripheral circuit structure UPST via the plurality of vertical through-electrodes TSV and the first memory cell structure CST1. The upper peripheral circuit structure UPST may have a face-up structure and the lower peripheral circuit structure DPST may have a face-up structure.

The first memory cell structure CST1 and the second memory cell structure CST2 may have substantially the same structure. For example, each of the first memory cell structure CST1 and the second memory cell structure CST2 may have substantially the same structure as the memory cell structure CSTa shown in FIGS. 10A and 10B. The semiconductor memory device 6 shown in FIGS. 12A and 12B has a structure in which the first memory cell structure CST1 is inserted between the lower peripheral circuit structure DPST and the upper peripheral circuit structure UPST in the semiconductor memory device 4 shown in FIGS. 10A and 10B and the second memory cell structure CST2 has a structure corresponding to the memory cell structure CSTa. Therefore, repeated descriptions as those given above are omitted. The first memory cell structure CST1 and the second memory cell structure CST2 may share the lower peripheral circuit structure DPST and the upper peripheral circuit structure UPST.

The plurality of upper contact plugs CTA may pass through the upper cover insulating layer CDU and the interlayer insulating layer ILD of the second memory cell structure CST2 and be electrically connected to the plurality of upper wiring lines PMLU. The plurality of lower contact plugs CTB may pass through the lower cover insulating layer CDD, the lower semiconductor substrate PSUBD, and the lower wiring insulating layer IMDD and be electrically connected to the plurality of lower wiring lines PMLD. The first memory cell structure CST1 may further include a plurality of through-electrode pads TSPD disposed on the plurality of third word lines WL3 that are located uppermost among the plurality of first word lines WL1, the plurality of second word lines WL2, and the plurality of third word lines WL3. The plurality of through-electrode pads TSPD may be electrically connected to the plurality of third word lines WL3. The interlayer insulating layer ILD in the first memory cell structure CST1 may surround the plurality of through-electrode pads TSPD. The lower surface of the bonding structure BDDI may be in contact with the upper surface of the interlayer insulating layer ILD and the upper surfaces of the plurality of through-electrode pads TSPD of the first memory cell structure CST1. The plurality of vertical through-electrodes TSV may pass through the upper wiring insulating layer IMDU, the upper semiconductor substrate PSUBU, and the bonding structure BDDI and be electrically connected to the plurality of through-electrode pads TSPD. The plurality of upper wiring lines PMLU may be electrically connected to the plurality of lower wiring lines PMLD via the plurality of vertical through-electrodes TSV, the plurality of through-electrode pads TSPD, and the plurality of memory cells MC of the first memory cell structure CST1. In some implementations, the first memory cell structure CST1 may further include a plurality of sub-vertical through-electrodes that pass through the interlayer insulating layer ILD and electrically connect the plurality of through-electrode pads TSPD to the plurality of lower wiring lines PMLD. For example, the plurality of upper wiring lines PMLU may be electrically connected to the plurality of lower wiring lines PMLD via the plurality of vertical through-electrodes TSV, the plurality of through-electrode pads TSPD, and the plurality of sub-vertical through-electrodes.

In some implementations, the upper peripheral circuit structure UPST in the semiconductor memory device 6 may be modified and thus disposed above the second memory cell structure CST2. For example, the upper peripheral circuit structure UPST disposed above the second memory cell structure CST2 may have a face-up structure, which is similar to the upper peripheral circuit structure UPST shown in FIG. 6. For example, the upper peripheral circuit structure UPST disposed above the second memory cell structure CST2 may have a face-down structure, which is similar to the upper peripheral circuit structure UPST shown in FIG. 7. In some implementations, the semiconductor memory device 6 may be modified such that the first memory cell structure CST1 is turned over or the second memory cell structure CST2 is turned over.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

As used herein, the terms "substantially," "about," and similar terms are used as terms of approximation and not as terms of degree, and are intended to account for the inherent variations in measured or calculated values that would be recognized by those of ordinary skill in the art. Parameters and/or ends of ranges that are quoted as being "about" a certain value (e.g. "about X") may be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%.

Embodiments are set out in the following Clauses:
Clause 1. A semiconductor memory device comprising:
   a lower peripheral circuit structure;
   an upper peripheral circuit structure;
   a memory cell structure; and
   a plurality of vertical through-electrodes configured to electrically connect the lower peripheral circuit structure to the upper peripheral circuit structure,
   wherein the lower peripheral circuit structure, the upper peripheral circuit structure and the memory cell structure overlap each other in a vertical direction,
   wherein the memory cell structure comprises
      a plurality of word lines extending in a first horizontal direction,
      a plurality of bit lines extending in a second horizontal direction that is different from the first horizontal direction, and
      a plurality of selectors between the plurality of word lines and the plurality of bit lines to constitute a plurality of memory cells,

   wherein the lower peripheral circuit structure comprises a lower semiconductor substrate and a plurality of lower transistors on a surface of the lower semiconductor substrate,
   wherein the upper peripheral circuit structure comprises an upper semiconductor substrate and a plurality of upper transistors on a surface of the upper semiconductor substrate,
   wherein each word line of the plurality of word lines is electrically connected to a respective lower transistor of the plurality of lower transistors and to a respective upper transistor of the plurality of upper transistors, wherein each lower transistor and each upper transistor connected by a word line at least partially overlap in the vertical direction, and
   wherein each bit line of the plurality of bit lines is electrically connected to a respective lower transistor of the plurality of lower transistors and to a respective upper transistor of the plurality of upper transistors, wherein each lower transistor and each upper transistor connected by a bit line at least partially overlap in the vertical direction.
Clause 2. The semiconductor memory device of Clause 1, further comprises:
   an upper wiring structure on the upper peripheral circuit structure and comprising an upper cover insulating layer and a plurality of upper contact plugs passing through the upper cover insulating layer and electrically connected to the upper peripheral circuit structure; and
   a lower wiring structure below the lower peripheral circuit structure and comprising a lower cover insulating layer and a plurality of lower contact plugs passing through the lower cover insulating layer and electrically connected to the lower peripheral circuit structure.
Clause 3. The semiconductor memory device of Clause 2, wherein the lower peripheral circuit structure comprises the lower semiconductor substrate, the plurality of lower transistors on the surface of the lower semiconductor substrate, a plurality of lower wiring lines, a plurality of lower wiring contacts configured to electrically connect the plurality of lower wiring lines to the plurality of lower transistors, and a lower wiring insulating layer surrounding the plurality of lower transistors, the plurality of lower wiring lines, and the plurality of lower wiring contacts,
   wherein the upper peripheral circuit structure comprises the upper semiconductor substrate, the plurality of upper transistors on the surface of the upper semiconductor substrate, a plurality of upper wiring lines, a plurality of upper wiring contacts configured to electrically connect the plurality of upper wiring lines to the plurality of upper transistors, and an upper wiring insulating layer surrounding the plurality of upper transistors, the plurality of upper wiring lines, and the plurality of upper wiring contacts,
   wherein the plurality of vertical through-electrodes connect the plurality of lower wiring lines to the plurality of upper wiring lines, wherein the plurality of upper contact plugs are connected to the plurality of upper wiring lines, and
   wherein the plurality of lower contact plugs are connected to the plurality of lower wiring lines.
Clause 4. The semiconductor memory device of any preceding Clause, further comprises a bonding structure comprising an insulating material, wherein the bonding structure is between the lower peripheral circuit structure and the upper peripheral circuit structure, and wherein the plurality of vertical through-electrodes extend through the bonding structure.
Clause 5. The semiconductor memory device of any preceding Clause, wherein each vertical through-electrode of the plurality of vertical through-electrodes has a tapered shape having a horizontal width that decreases from the lower peripheral circuit structure toward the upper peripheral circuit structure.
Clause 6. The semiconductor memory device of any preceding Clause, wherein each selector of the plurality of selectors comprises a selection material layer, a first selection electrode layer between the selection material layer and a respective bit line of the plurality of bit lines, and a second selection electrode layer between a respective word line of the plurality of word lines and the selection material layer.
Clause 7. A semiconductor memory device comprising:
   a lower peripheral circuit structure comprising a lower semiconductor substrate, a plurality of lower local word line selection transistors, and a plurality of lower local bit line selection transistors,
   wherein the plurality of lower local word line selection transistors and the plurality of lower local bit line selection transistors are on a surface of the lower semiconductor substrate;
   an upper peripheral circuit structure provided above the lower peripheral circuit structure and comprising an upper semiconductor substrate, a plurality of upper local word line selection transistors, and a plurality of upper local bit line selection transistors,
   wherein the plurality of upper local word line selection transistors and the plurality of upper local bit line selection transistors are on a surface of the upper semiconductor substrate;
   a memory cell structure on the upper peripheral circuit structure and comprising
      a plurality of word lines extending in a first horizontal direction,
      a plurality of bit lines at a different vertical level from that of the plurality of word lines and extending in a second horizontal direction that is different from the first horizontal direction,
      a plurality of selectors between the plurality of word lines and the plurality of bit lines to constitute a plurality of memory cells, and
      an interlayer insulating layer surrounding the plurality of word lines, the plurality of bit lines, and the plurality of memory cells;
   a lower wiring structure below the lower peripheral circuit structure and comprising a lower cover insulating layer and a plurality of lower contact plugs passing through the lower cover insulating layer and electrically connected to the lower peripheral circuit structure;
   an upper wiring structure above the memory cell structure and comprising an upper cover insulating layer and a plurality of upper contact plugs passing through the upper cover insulating layer and electrically connected to the upper peripheral circuit structure; and
   a plurality of vertical through-electrodes configured to electrically connect the lower peripheral circuit structure to the upper peripheral circuit structure,
   wherein each word line of the plurality of word lines is electrically connected to a respective lower local word line selection transistor of the plurality of lower local word line selection transistors and to a respective upper local word line selection transistor of the plurality of upper local word line selection transistors, and wherein each lower local word line selection transistor and each upper local word line selection transistor connected by a word line at least partially overlap in a vertical direction,
   wherein each bit line of the plurality of bit lines is electrically connected to a respective lower local bit line selection transistor of the plurality of lower local bit line selection transistors and to a respective upper local bit line selection transistor of the plurality of upper local bit line selection transistors, and
   wherein each lower local bit line selection transistor and each upper local bit line selection transistor connected by a bit line at least partially overlap in the vertical direction.
Clause 8. The semiconductor memory device of Clause 7, wherein the lower peripheral circuit structure comprises
   the lower semiconductor substrate,
   the plurality of lower local word line selection transistors and the plurality of lower local bit line selection transistors, on the surface of the lower semiconductor substrate,
   a plurality of lower wiring lines,
   a plurality of lower wiring contacts configured to electrically connect the plurality of lower wiring lines to the plurality of lower local word line selection transistors and the plurality of lower local bit line selection transistors, and
   a lower wiring insulating layer surrounding the plurality of lower wiring lines and the plurality of lower wiring contacts,
      the upper peripheral circuit structure comprises
   the upper semiconductor substrate,
   the plurality of upper local word line selection transistors and the plurality of upper local bit line selection transistors, which are on the surface of the upper semiconductor substrate,
   a plurality of upper wiring lines,
   a plurality of upper wiring contacts configured to electrically connect the plurality of upper wiring lines to the plurality of the upper local word line selection transistors and the plurality of upper local bit line selection transistors, and
      an upper wiring insulating layer surrounding the plurality of upper wiring lines and the plurality of upper wiring contacts,

   wherein the plurality of lower contact plugs are connected to the plurality of lower wiring lines, and
   wherein the plurality of upper contact plugs are connected to the plurality of upper wiring lines.
Clause 9. The semiconductor memory device of Clause 8, wherein the plurality of vertical through-electrodes connect the plurality of lower wiring lines to the plurality of upper wiring lines, and
   wherein each vertical through-electrode of the plurality of vertical through-electrodes electrically connects each word line of the plurality of word lines to a respective one of the plurality of lower local word line selection transistors and a respective one of the plurality of upper local word line selection transistors, or electrically connects each bit line of the plurality of bit lines to a respective one of the plurality of lower local bit line selection transistors and a respective one of the plurality of upper local bit line selection transistors.
Clause 10. The semiconductor memory device of Clause 9, wherein the memory cell structure further comprises:
   a plurality of word line contacts passing through the interlayer insulating layer and configured to connect the plurality of word lines to the plurality of upper wiring lines; and
   a plurality of bit line contacts passing through the interlayer insulating layer and configured to connect the plurality of bit lines to the plurality of upper wiring lines.
Clause 11. The semiconductor memory device of any of Clauses 8-10, wherein each vertical through-electrode of the plurality of vertical through-electrodes has a tapered shape having a horizontal width that decreases from the plurality of lower wiring lines to the plurality of upper wiring lines, while passing through the lower wiring insulating layer, the lower semiconductor substrate, the upper semiconductor substrate, and the upper wiring insulating layer.
Clause 12. The semiconductor memory device of any of Clauses 8-11, wherein each upper contact plug of the plurality of upper contact plugs passes through the upper cover insulating layer and the interlayer insulating layer and has a tapered shape having a horizontal width that decreases while extending to the plurality of upper wiring lines, and
   wherein each lower contact plug of the plurality of lower contact plugs passes through the lower cover insulating layer and has a tapered shape having a horizontal width that decreases while extending to the plurality of lower wiring lines.
Clause 13. The semiconductor memory device of any one of Clauses 7-12, wherein each selector of the plurality of selectors comprises a selection material layer having ovonic threshold switching characteristics, a first selection electrode layer between the selection material layer and a respective bit line of the plurality of the bit lines, and a second selection electrode layer between a respective word line of the plurality of word lines and the selection material layer, and
   wherein each of the first selection electrode layer and the second selection electrode layer comprises carbon or a conductive material containing the carbon.
Clause 14. A semiconductor memory device comprising:
   a lower peripheral circuit structure comprising a lower semiconductor substrate, a plurality of lower local word line selection transistors and a plurality of lower local bit line selection transistors on a surface of the lower semiconductor substrate, a plurality of lower wiring lines, a plurality of lower wiring contacts configured to electrically connect the plurality of lower wiring lines to the plurality of lower local word line selection transistors and the plurality of lower local bit line selection transistors, and a lower wiring insulating layer surrounding the plurality of lower wiring lines and the plurality of lower wiring contacts;
   an upper peripheral circuit structure above the lower peripheral circuit structure and comprising an upper semiconductor substrate, a plurality of upper local word line selection transistors and a plurality of upper local bit line selection transistors on a surface of the upper semiconductor substrate, a plurality of upper wiring lines, a plurality of upper wiring contacts configured to electrically connect the plurality of upper wiring lines to the plurality of the upper local word line selection transistors and the plurality of upper local bit line selection transistors, and an upper wiring insulating layer surrounding the plurality of upper wiring lines and the plurality of upper wiring contacts;
   a memory cell structure above the upper peripheral circuit structure and comprising a plurality of word lines extending in a first horizontal direction, a plurality of bit lines above the plurality of word lines and extending in a second horizontal direction that is different from the first horizontal direction, a plurality of selectors located between the plurality of word lines and the plurality of bit lines, a plurality of word line contacts connecting the plurality of word lines to the plurality of upper wiring lines, a plurality of bit line contacts connecting the plurality of bit lines to the plurality of upper wiring lines, and an interlayer insulating layer surrounding the plurality of word line contacts, the plurality of bit line contacts, the plurality of word lines, the plurality of bit lines, and the plurality of selectors,
   wherein each selector of the plurality of selectors comprises a selection material layer, a first selection electrode layer between the selection material layer and a respective bit line, and a second selection electrode layer between a respective word line and the selection material layer;
   a lower wiring structure below the lower peripheral circuit structure and comprising a lower cover insulating layer and a plurality of lower contact plugs passing through the lower cover insulating layer and electrically connected to the plurality of lower wiring lines;
   an upper wiring structure above the memory cell structure and comprising an upper cover insulating layer and a plurality of upper contact plugs passing through the upper cover insulating layer and electrically connected to the plurality of upper wiring lines; and
   a plurality of vertical through-electrodes passing through the lower wiring insulating layer, the lower semiconductor substrate, the upper semiconductor substrate, and the upper wiring insulating layer and connecting the plurality of lower wiring lines to the plurality of upper wiring lines,
   wherein each word line of the plurality of word lines is configured to be electrically connected to a respective lower local word line selection transistor of the plurality of lower local word line selection transistors and to a respective upper local word line selection transistor of the plurality of upper local word line selection transistors, wherein each lower local word line selection transistor and each upper local word line selection transistor connected by a word line at least partially overlap in a vertical direction, and
   wherein each bit line of the plurality of bit lines is configured to be electrically connected to a respective lower local bit line selection transistor of the plurality of lower local bit line selection transistors and to a respective upper local bit line selection transistor of the plurality of upper local bit line selection transistors, wherein each lower local bit line selection transistor and each upper local bit line selection transistor connected by a bit line at least partially overlap in the vertical direction.
Clause 15. The semiconductor memory device of Clause 14, wherein each vertical through-electrode of the plurality of vertical through-electrodes has a tapered shape having a horizontal width that decreases while extending from the plurality of lower wiring lines to the plurality of upper wiring lines,
   wherein each upper contact plug of the plurality of upper contact plugs has a tapered shape having a horizontal width that decreases while extending toward the plurality of upper wiring lines, and
   wherein each lower contact plug of the plurality of lower contact plugs has a tapered shape having a horizontal width that decreases while extending toward the plurality of lower wiring lines.

While the semiconductor memory device that operates bidirectionally has been particularly shown and described with reference to implementations thereof, it will be understood that various changes in form and details may be made therein without departing from the scope of the following claims.

## Claims

1. A semiconductor memory device comprising:
a lower peripheral circuit structure (DPST);
an upper peripheral circuit structure (UPST);
a memory cell structure (CST); and
a plurality of vertical through-electrodes (TSV) configured to electrically connect the lower peripheral circuit structure (DPST) to the upper peripheral circuit structure (UPST),
wherein the lower peripheral circuit structure (DPST), the upper peripheral circuit structure (UPST) and the memory cell structure (CST) overlap each other in a vertical direction,
wherein the memory cell structure (CST) comprises
a plurality of word lines (WL) extending in a first horizontal direction,
a plurality of bit lines (BL) extending in a second horizontal direction that is different from the first horizontal direction, and
a plurality of selectors (SLT) between the plurality of word lines (WL) and the plurality of bit lines (BL) to constitute a plurality of memory cells (MC),
wherein the lower peripheral circuit structure (DPST) comprises a lower semiconductor substrate (PSUBD) and a plurality of lower transistors on a surface of the lower semiconductor substrate (PSUBD),
wherein the upper peripheral circuit structure (UPST) comprises an upper semiconductor substrate (PSUBU) and a plurality of upper transistors on a surface of the upper semiconductor substrate (PSUBU),
wherein each word line (WL) of the plurality of word lines (WL) is electrically connected to a respective lower transistor (LX-R) of the plurality of lower transistors and to a respective upper transistor (LX-F) of the plurality of upper transistors, wherein each lower transistor (LX-R) and each upper transistor (LX-F) connected by a word line (WL) at least partially overlap in the vertical direction, and
wherein each bit line (BL) of the plurality of bit lines (BL) is electrically connected to a respective lower transistor (LY-R) of the plurality of lower transistors and to a respective upper transistor (LY-F) of the plurality of upper transistors, wherein each lower transistor (LY-R) and each upper transistor (LY-F) connected by a bit line (BL) at least partially overlap in the vertical direction.

2. The semiconductor memory device of claim 1, further comprising:
an upper wiring structure (FPST) on the upper peripheral circuit structure (UPST) and comprising an upper cover insulating layer (CDU) and a plurality of upper contact plugs (CTA) passing through the upper cover insulating layer (CDU) and electrically connected to the upper peripheral circuit structure (UPST); and
a lower wiring structure (BPST) below the lower peripheral circuit structure (DPST) and comprising a lower cover insulating layer (CDD) and a plurality of lower contact plugs (CTB) passing through the lower cover insulating layer (CDD) and electrically connected to the lower peripheral circuit structure (DPST).

3. The semiconductor memory device of claim 2, wherein the lower peripheral circuit structure (DPST) comprises the lower semiconductor substrate (PSUBD), the plurality of lower transistors on the surface of the lower semiconductor substrate (PSUBD), a plurality of lower wiring lines (PMLD), a plurality of lower wiring contacts (PMCD) configured to electrically connect the plurality of lower wiring lines (PMLD) to the plurality of lower transistors, and a lower wiring insulating layer (IMDD) surrounding the plurality of lower transistors, the plurality of lower wiring lines (PMLD), and the plurality of lower wiring contacts (PMCD),
wherein the upper peripheral circuit structure (UPST) comprises the upper semiconductor substrate (PSUBU), the plurality of upper transistors on the surface of the upper semiconductor substrate (PSUBU), a plurality of upper wiring lines (PMLU), a plurality of upper wiring contacts (PMCU) configured to electrically connect the plurality of upper wiring lines (PMLU) to the plurality of upper transistors, and an upper wiring insulating layer (IMDU) surrounding the plurality of upper transistors, the plurality of upper wiring lines (PMLU), and the plurality of upper wiring contacts (PMCU),
wherein the plurality of vertical through-electrodes (TSV) connect the plurality of lower wiring lines (PMLD) to the plurality of upper wiring lines (PMLU),
wherein the plurality of upper contact plugs (CTA) are connected to the plurality of upper wiring lines (PMLU), and
wherein the plurality of lower contact plugs (CTB) are connected to the plurality of lower wiring lines (PMLD).

4. The semiconductor memory device of claim 3, wherein:
the memory cell structure (CST) further comprises an interlayer insulating layer (ILD) surrounding the plurality of word lines (WL), the plurality of bit lines (BL), and the plurality of memory cells (MC).

5. The semiconductor memory device of claim 4 wherein the memory cell structure (CST) further comprises:
a plurality of word line contacts (WLC) passing through the interlayer insulating layer (ILD) and configured to connect the plurality of word lines (WL) to the plurality of upper wiring lines (PMLU); and
a plurality of bit line contacts (BLC) passing through the interlayer insulating layer (ILD) and configured to connect the plurality of bit lines (BL) to the plurality of upper wiring lines (PMLU).

6. The semiconductor memory device of claim 4 or claim 5 wherein each upper contact plug (CTA) of the plurality of upper contact plugs (CTA) passes through the upper cover insulating layer (CDU) and the interlayer insulating layer (ILD) and has a tapered shape having a horizontal width that decreases while extending to the plurality of upper wiring lines (PMLU), and
wherein each lower contact plug (CTB) of the plurality of lower contact plugs (CTB) passes through the lower cover insulating layer (CDD) and has a tapered shape having a horizontal width that decreases while extending to the plurality of lower wiring lines (PMLD).

7. The semiconductor memory device of any preceding claim, further comprising a bonding structure (BDDI) comprising an insulating material, wherein the bonding structure (BDDI) is between the lower peripheral circuit structure (DPST) and the upper peripheral circuit structure (UPST), andw
wherein the plurality of vertical through-electrodes (TSV) extend through the bonding structure.

8. The semiconductor memory device of any preceding claim, wherein each vertical through-electrode (TSV) of the plurality of vertical through-electrodes (TSV) has a tapered shape having a horizontal width that decreases from the lower peripheral circuit structure (DPST) toward the upper peripheral circuit structure (UPST).

9. The semiconductor memory device of claim 8, when dependent on claim 3, wherein, for each vertical through-electrode (TSV), the horizontal width decreases from the plurality of lower wiring lines (PMLD) to the plurality of upper wiring lines (PMLU), while the vertical through-electrode (TSV) passes through the lower wiring insulating layer (IMDD), the lower semiconductor substrate (PSUBD), the upper semiconductor substrate (PSUBU), and the upper wiring insulating layer (IMDU).

10. The semiconductor memory device of any preceding claim, wherein each selector (SLT) of the plurality of selectors (SLT) comprises a selection material layer (SML), a first selection electrode layer (EL1) between the selection material layer (SML) and a respective bit line (BL) of the plurality of bit lines (BL), and a second selection electrode layer (EL2) between a respective word line (WL) of the plurality of word lines (WL) and the selection material layer (SML).

11. The semiconductor memory device of claim 10, wherein the selection material layer (SML) has ovonic threshold switching characteristics, and
wherein each of the first selection electrode layer (EL1) and the second selection electrode layer (EL2) comprises carbon or a conductive material containing the carbon.

12. The semiconductor memory device of any preceding claim:
the lower transistors (LX-R) that are connected to the word lines (WL) are lower local word line selection transistors (LX-R), and the lower transistors (LY-R) that are connected to bit lines (BL) are lower local bit line selection transistors (LY-R); and
the upper transistors (LX-F) that are connected to word lines (WL) are upper local word line selection transistors (LX-F), and the upper transistors (LY-F) that are connected to bit lines (BL) are upper local bit line selection transistors (LY-F).

13. The semiconductor memory device of claim 12, wherein the plurality of vertical through-electrodes (TSV) connect the plurality of lower wiring lines (PMLD) to the plurality of upper wiring lines (PMLU), and
wherein each vertical through-electrode (TSV) of the plurality of vertical through-electrodes (TSV) electrically connects a corresponding word line (WL) of the plurality of word lines (WL) to a respective one of the plurality of lower local word line selection transistors (LX-R) and a respective one of the plurality of upper local word line selection transistors (LX-F), or electrically connects a corresponding bit line of the plurality of bit lines (BL) to a respective one of the plurality of lower local bit line selection transistors (LY-R) and a respective one of the plurality of upper local bit line selection transistors (LY-F).

14. The semiconductor memory device of any preceding claim wherein plurality of bit lines (BL) are at a different vertical level from that of the plurality of word lines (WL).

15. The semiconductor memory device of claim 14 wherein the plurality of bit lines are above the plurality of word lines.
